# EUROPEAN PATENT APPLICATION

(11) **EP 3 593 992 A1**
(43) Date of publication of application: **15.01.2020**
(21) Application number: 19173228.8
(22) Date of filing: 24.10.2012
(51) Int. Cl.: B32B 7/04, H05B 33/04, B82Y 30/00, C23C 28/00, H01L 51/52, H01L 23/29, H01L 21/56, H01L 51/10, H01L 51/44

(54) **ENCAPSULATION BARRIER STACK**

(30) Priority: 24.10.2011 US 201161550764 P
(62) Divisional of application: 12843853.8
(71) Applicant: Tera-Barrier Films Pte Ltd, 117586 Singapore (SG); Agency for Science, Technology and Research, Singapore 138632 (SG)
(72) Inventor: RAMADAS, Senthil Kumar, 469337 Singapore (SG); SHANMUGAVEL, Saravanan, 120711 Singapore (SG)
(74) Representative: Schiweck Weinzierl Koch Patentanwälte Partnerschaft mbB

(57) **Abstract**

Disclosed is an encapsulation barrier stack, capable of encapsulating a moisture and/or oxygen sensitive article and comprising a multilayer film, wherein the multilayer film comprises:
- one or more barrier layer(s) having low moisture and/or oxygen permeability, and
- one or more sealing layer(s) arranged to be in contact with a surface of the at least one barrier layer, thereby covering defects present in the barrier layer,
wherein the one or more sealing layer(s) comprise(s) a plurality of encapsulated nanoparticles, the nanoparticles being reactive in that they are capable of interacting with moisture and/or oxygen to retard the permeation of moisture and/or oxygen through the defects present in the barrier layer. The encapsulation of the particles can be obtained by polymerising a polymerisable compound (a monomeric or a polymeric compound with polymerisible groups or) cross-linking a cross-linkable compound on the surface of the reactive nanoparticles.

## Description

### CROSS-REFENCE TO RELATED APPLICATIONS

The present application claims the right of priority of US provisional application 61/550,764 filed with the US Patent and Trademark Office on 24 October 2011, the entire content of which is incorporated herein for all purposes.

### FIELD OF THE INVENTION

The present invention relates to the field of barrier stacks, and more particularly to a barrier stack that includes encapsulated nanoparticles. The encapsulation of the particles can be obtained by partially or fully encapsulating with an organic material, which includes a polymerising a polymerisable compound (a monomeric or a polymeric compound with polymerisible groups or) cross-linking a cross-linkable compound on the surface of the reactive nanoparticles. The encapsulated nanoparticles may be deposited on to inorganic thin oxide (barrier) films. A respective barrier stack can be arranged on a substrate, for example in an electronic device.

### BACKGROUND OF THE INVENTION

Flexible solar cells and flexible plastic or printed electronics are considered as a next generation display technology. However, like many new technologies of the future, many technical questions have to be resolved such as those related to the high gas barrier performance and the cost of the polymeric substrates. Polymer films do not typically show high barrier performance (as compared to the requirement of less than 10⁻⁵ to 10⁻⁶g/m²/day permeability of water vapour at 39°C and 95% relative humidity) even if they are coated with a metal-oxide coating to improve their barrier properties. It is well known that high barrier thin film oxides, coated onto plastic films, have imperfections such as pinholes, cracks, grain boundaries, etc. which vastly affect the performance of barrier films. The integrity of deposited coatings is a critical factor in determining the overall gas barrier performance and the control of defects within the oxide layers is a most important. Indeed, the performance of the metal-oxide-coated polymer films and the cost is a major technological hurdle towards a breakthrough in flexible solar cells, flexible OLED displays and plastic electronics applications. It is well known that multi-layer inorganic and organic barrier films decouple the defects of the barrier oxide films. These barrier films can only enhance the barrier properties, but don't address other properties such as mechanical, optical and weatherability.

The global solar cell industry has seen a significant growth in recent years, with a compound annual growth rate above 50% for the last 10 years. The downside of this rapid expansion has been an oversupply of solar cell modules leading to a dramatic price decrease of more than 50% over the last 2 years. The target price of US$ 1/Watt has been broken already for solar cells.

The price structure for a module with 12% efficiency and a price target of US$ 0.7/W would mean a module price of US$ 84/m². Out of this encapsulation and barrier films comprise 30% to 35%, i.e. US$ 25 - 30. This would include substrates (top and bottom) as well as sealants and other protective laminates. Since the base substrate generally is a lower cost metal film, the barrier film share would be in the range of US$ 15-20/m² maximum. If the PV module price continues to decline (as expected by many industry analysts), the barrier film share of the total PV module product cost would be in the range of US$ 10/m². Similarly for OLED lighting applications, the cost expectation is similar to the PV applications. This invention proposes to reduce the production cost of the barrier stack and provide additional cost benefits by enhancing the UV blocking and anti-reflection properties. Therefore, the proposed barrier stack design can provide barrier and optical properties at lower cost for PV and OLED lighting applications.

Manufacturers of flexible solar cells have set their target at less than US$ 1/Watt, since their flexible rolls of solar modules are easily transported and installed. Currently, CIGS manufacturers have achieved more than 12% efficiency on their regular roll-to-roll production lines, with champion efficiencies of more than 16%.

Most of the barrier coating technologies are based on the use of oxide barrier films in their barrier stack in order to get high barrier properties. These oxide barrier films are deposited on the plastic substrates by Sputtering (Physical Vapour Deposition) processes and PECVD methods. However, the most preferred method is the sputtering process, which can provide high packing density of oxide films, which has lower density of defects such as pinholes, cracks and other defects such as grain boundary. The atomic layer deposition can also provide high packing density barrier films with lower number of defects, but the production throughput is currently lower than sputtering The Roll-to-Roll production systems and efforts in increasing production throughput are under development stage. However, efforts have been taken to increase the production speed by Roll-to-Roll processes, which are currently being developed. The typical barrier properties which can be achieved by Sputtering and ALD techniques are in the order of 0.02 g/m^{2.}day to 0.006 g/m^{2.}day at 38 °C and 90% relative humidity. Nevertheless, the sputtering technology has already reached a matured stage, and Roll-to-Roll coating manufacturing plants are commercially available. However, with sputtering, the coating throughput is still very low, in the range of 2.5 meters/min to 4.9 meters/min. Therefore, the production cost of the barrier oxide films such as aluminium oxide by a sputtering process would be considerably high, typically S$2.00 to S$5.00/m² depending on coating plant specification and configuration. Most barrier stack designs require at least 3-barrier oxide layers and 3 polymer-decoupling layers. Therefore, the 3 layer-system production costs would dramatically increase up to S$18 to S$28/m². In addition to the base substrate cost, further cost factors are UV filter costs and anti-reflection coating costs as well as operational costs which would turn out to be uneconomical for PV and OLED lighting manufacturers.

The high speed manufacturing process (500 - 1000 meters/min) of Electron Beam and Plasma enhanced evaporation methods provide flexibility for the use of different coatings with the high robustness, high adhesion and extremely good transmittance/transparency. Electron beam evaporation or plasma enhanced evaporation methods could achieve a throughput in the range of 400 meters/min to 900 meters/min. However, the metal oxide film integrity is poor when compared to the sputtering/plasma-enhanced chemical vapor deposition (PECVD) processes. The evaporation processes such as plasma-enhanced physical vapor deposition (PEPVD) methods could only provide lower packing density oxide films and the film properties are columnar structure and high porous films. The barrier properties typically show 1.5g/m^{2.}day to 0.5 g/m^{2.}day at 38 °C and 90% relative humidity. The barrier oxide production cost by high speed manufacturing process typically is in the range of S$0.20¢ to 0.40¢/m². PECVD, which can achieve a throughput of 50 meters/min to 100 meters/min, was proposed by many researchers since PECVD provides better barrier properties than PEPVD methods. The production cost of PECVD barrier films are however comparatively higher than PEPVD methods since capital cost and consumable cost is higher than for PEPVD methods. In addition, metal oxide films produced by a high speed manufacturing process in the art (500m/min to 1000m/min) exhibit a porous microstructure and have numerous defects.

It is therefore an object of the present invention to provide a barrier stack system that overcomes at least some of the above drawbacks. In this regard it is also an object of the invention to provide a barrier stack system with improved flexibility, gas barrier properties, weatherability, optical, mechanical properties and reliability of flexible high barrier substrate system and also to provide cost effective solutions. This object is solved by the subject matter of the independent claims.

### SUMMARY OF THE INVENTION

In one aspect, the invention provides an encapsulation barrier stack, capable of encapsulating a moisture and/or oxygen sensitive article and comprising a multilayer film, wherein the multilayer film comprises:
one or more barrier layer(s) having low moisture and/or oxygen permeability, and
one or more sealing layer(s) arranged to be in contact with a surface of the at least one barrier layer, thereby covering and/ or plugging defects present in the barrier layer, wherein the one or more sealing layer(s) comprise(s) a plurality of encapsulated nanoparticles, the nanoparticles being reactive in that they are capable of interacting with moisture and/or oxygen to retard the permeation of moisture and/or oxygen.

In another aspect, the invention provides an electronic module comprising an electronic device that is sensitive to moisture and/or oxygen, wherein the electronic device is arranged within an encapsulation barrier stack according to invention.

In yet another aspect, the invention provides a method of manufacturing an encapsulation barrier stack, the method comprising:
providing one or more barrier layer(s), and
forming one or more sealing layer(s), wherein forming the one or more sealing layer(s) comprises
   (i) mixing a polymerisable compound or a cross-linkable compound with a plurality of nanoparticles, the nanoparticles being reactive in that they are capable of interacting with moisture and/or oxygen, thereby forming a sealing mixture,
   (ii) applying the sealing mixture onto the barrier layer and polymerising the polymerisable compound or to cross-link the cross-linkable compound to form a polymer under conditions allowing the nanoparticles to be encapsulated by the formed polymer.

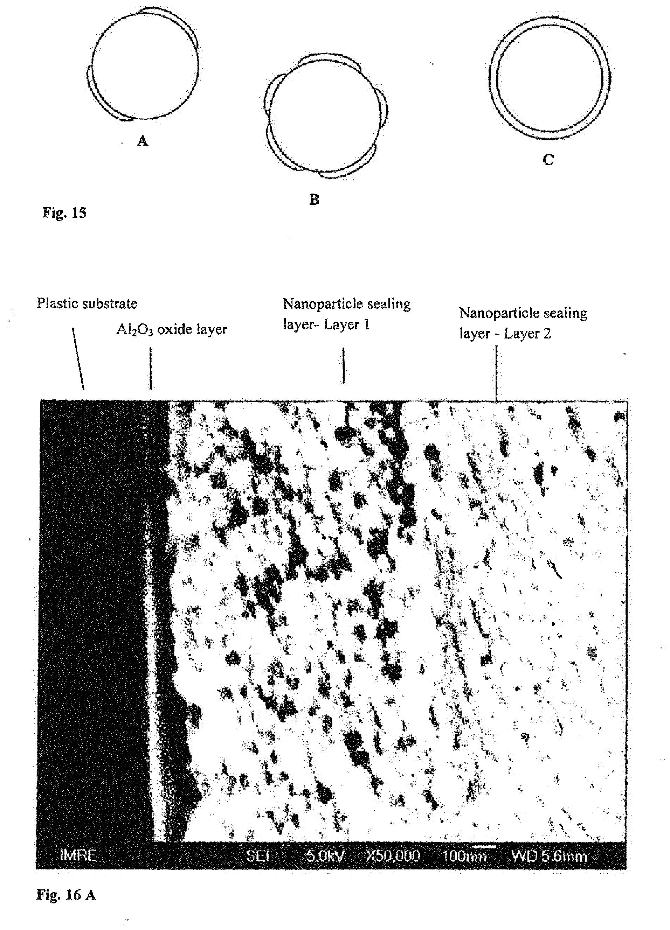

An encapsulation barrier stack according to the invention has encapsulated nanoparticles, in some embodiments polymer is also used as an encapsulation material or for the functionalization of nanoparticles. In this context, it is noted that the term "encapsulated" does not necessarily mean that the entire surface of the reactive nanoparticle is coated/encapsulated with the cured polymerisable compound. Rather than the surface of the nanoparticle being 100% encapsulated, it is also encompassed in the present invention that only about 50% or more, or about 60% or more, or about 75% or more, or about 80 % or more, or about 85% or more, or about 90% or more or about 95% or more of the surface of the reactive nanoparticles are encapsulated, or in other words, passivated by the encapsulation material after forming the encapsulation, by for example curing or cross-linking of the polymerisable/crosslinkable compound (cf. also **Fig. 15**). The present inventors have also surprisingly found that these nanoparticles are capable of sealing or plugging defects and that they also enhance gas barrier properties. In addition an encapsulated barrier stack according to the invention is a low-cost device that has multi-functional properties including UV light blocking and has excellent anti-reflection properties.

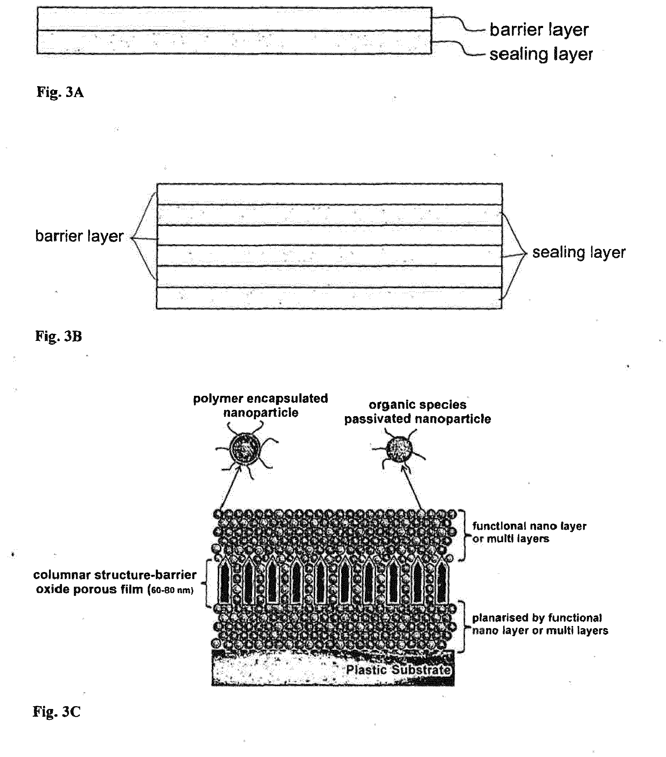

An encapsulated barrier stack of the invention may have a barrier layer, which may be an oxide film, as well as a sealing layer. The sealing layer may contain functionalized nanoparticles, which are either encapsulated or passivated by polymer or other organic species such as oligomers. The sealing layer may in some embodiments be a single layer. In some embodiments the encapsulated barrier stack has a single sealing layer. In some embodiments the encapsulated barrier stack includes multiple sealing layers. Examples of embodiments of the general build-up of a barrier stack according to the invention are depicted in **Fig. 3****.**

The present disclosure provides a barrier stack with improved flexibility, gas barrier, weatherability, optical, mechanical properties and reliability, and also provides a cost effective solution.

According to a first aspect, the present invention provides an encapsulation barrier stack. The encapsulation barrier stack is capable of encapsulating a moisture and/or oxygen sensitive article. The encapsulation barrier stack includes a multilayer film. The multilayer film includes one or more barrier layer(s) and one or more sealing layers comprising nanoparticles encapsulated by organic species that provide low moisture and/or oxygen permeability. The multilayer film further includes one or more sealing layer(s). The one or more sealing layer(s) are arranged to be in contact with a surface of the at least one barrier layer. Thereby the one or more sealing layer(s) cover defects present in the barrier layer. The one or more sealing layer(s) include(s) a plurality of organic species, for example, polymer encapsulated nanoparticles. The nanoparticles are reactive in that they are capable of interacting with moisture and/or oxygen to retard the permeation of moisture and/or oxygen through the defects present in the barrier layer.

According to a second aspect, the invention provides an electronic device. The electronic device includes an active component that is sensitive to moisture and/or oxygen. The active component is arranged within an encapsulation barrier stack according to the first aspect.

According to a third aspect, the invention provides a method of manufacturing an encapsulation barrier stack according to the first aspect. The method includes providing one or more barrier layer(s). The method also includes forming one or more sealing layer(s). Forming the one or more sealing layer(s) includes mixing an organic species with a plurality of nanoparticles or functionalized nanoparticles. The organic (polymerisable or cross-linkable) species include monomers, polymer and/or oligomer or combinations thereof. The surfaces of functionalized nanoparticles often possess highly reactive dangling bonds, which may be passivated by coordination of a suitable ligand such as an organic ligand or species or polymer compound. The polymer (or monomer) or an organic ligand compound is typically either dissolved in a solvent together with a surfactant or silane mixture or a combination thereof. There are many approaches that can be undertaken to encapsulate nanoparticles by a suitable organic species, which may include, but is not limited to "ligand exchange" and "cross-linked" approaches. The nanoparticles are usually present in the sealing in a rather high amount, and typically make up more than 80%, more than 85 % or more than 90% of the total mass of the sealing layer, meaning that the weight of the organic encapsulation material (polymer or oligomer) is 20 % or less of the total weight of the total weight of the sealing layer. In some embodiments the weight of the nanoparticles is 90% to 95%, including 91 %, 92 %, 93 % and 94 % (w/w). In other embodiments, the weight of the nanoparticles is 96, 97 or 98 % (w/w) of the weight of the sealing layer. In typical embodiments most or ideally each nanoparticle is encapsulated with the organic species. Therefore, the nanoparticle layer has a high packing density and provides strong bonding between the particles due the encapsulated organic material. The ratio of nanoparticles to organic species is important for the high packing density and desired properties. A preferable ratio of nanoparticles to organic species is 19:1 (weight by weight). In certain embodiments and depending on the desired properties the weight ratio of nanoparticles to organic species may be 9:1 or 12:1 or 15:1. The invention focuses to reduce the amount of organic species or polymer content of the encapsulation to the minimum such that the encapsulation can even be only partial. In one embodiment, the encapsulation material used enhances the bond strength between adjacent particles and enhances oxygen and barrier properties. The encapsulation material may cover only 50 to 90%, or 95% or up to 100% of the surface area of the nanoparticle. And therefore, the moisture or oxygen permeates through the encapsulation material, and the nanoparticle can react with the oxygen and moisture. Therefore, the overall permeation through the sealing layer is minimised. In one of the embodiment the encapsulation material may be reactive or non-reactive.

In one embodiment forming the one or more sealing layer(s) also includes applying the sealing mixture onto the barrier layer and polymerising the polymerisable compound to form a polymer. The polymer forming monomer precursors such as a silane, acrylate, or imidazole compound (or mixtures thereof) are polymerized on the nanoparticle surface. In order to ensure that the polymerization starts from the particle surface, the monomers are chosen with functional groups that can adsorb on the particle surface and polymerization is performed in a controlled manner. For example but not limited to, bis-(6-aminohexyl) amine can be used to cross-link between polymaleic anhydride based polymers chains on the nanoparticle surface via reaction of primary amines with anhydride group. The key issue can be resolved in producing encapsulated nanoparticle with maximum particle - particle linkage by selection of monomers and optimization of mixing and reaction conditions. The thickness of encapsulation shell can be controlled by varying the experimental condition such as method of mixing time or methods, reaction time, reaction medium or by selecting right monomers. In some embodiments the preferred nanoparticle thickness is about 20nm without organic encapsulation. The preferred encapsulation or shell thickness may be in the range of about 5 angstrom to about 100 angstrom. Therefore, the polymer is formed under conditions that allow the nanoparticles to be encapsulated by the formed polymer. In this context, it is noted that conditions that allow the nanoparticles to be encapsulated as for example, conditions in which the polymerisable compound is present in the sealing mixture in such a concentration that the polymerisable compound will interact with the nanoparticles. Such condition may include using a low concentration of the polymerisable compound in the sealing mixture. For example, in such a liquid sealing solution the polymerisable compound may be present in a concentration of about 5 % (w/v) or less, or 10 % /w/v) of the sealing mixture or of 3 % (w/v) or of 5% (w/v) of the sealing mixture. Expressed differently, such conditions might also be achieved by using less than 10 wt.-% or less that 25 wt.-% or less (dry form) of the polymerisable compound of the weight of the reactive nanoparticles (that means a weight ratio of 1:9 or of 1:4). The weight ratio of the polymerisable compound (which can be a monomeric compound) to reactive nanoparticles weight also is 1: 9, or 1:12, or 1:15, or 1:19 or less. Under such conditions, a sealing solution contains such low concentrations of the polymerisable compound (a monomeric compound, for example) that the polymerisable compound is adsorbed on the reactive nanoparticle, thereby coating the reactive nanoparticles with the polymerisable compound. In order to facilitate conditions that allow the nanoparticles to be encapsulated, the sealing solution may also be sonificated such that polymerisable compound is mixed with the nanoparticles and the freely moving reactive nanoparticles are coated with the polymerisable compound during the sonification treatment. If such a sealing solution is then applied onto a barrier layer and exposed to curing conditions, curing creates a cross-linked (polymerized) compound on the surface of reactive nanoparticles and, possibly, also between different nanoparticles. In some embodiments, before curing, heating may be required after the coating process. The mixing may be undertaken under inert environment if reactive nanoparticles are used. However, if crosslinking between different nanoparticles occurs during the curing, the sealing layer as described here does not form a polymer matrix as described in US Patent 8,039,739 or the international patent applicationsWO 2005/0249901 A1 and WO2008/057045 in which the nanoparticles are distributed and embedded. Rather, the sealing layer is formed substantially (say to about at least 80%, or 90%, or 95% or 100% of the surface of nanoparticle covered by encapsulation material) or entirely by the individually encapsulated nanoparticles. A variety of chemical functionalities such as amine, carboxylate, polyethylene glycol (PEG) can be introduced on the coating backbone by selecting different polymer-forming monomer precursors. These cross-linked encapsulations provide an excellent colloidal stability without affecting the properties or functionalities of the core nanoparticle.

Another embodiment of the present invention features a sealing layer that comprises of a nanoparticle composition that includes or consists essentially of nanoparticle encapsulated within a self-assembled layer including an amphiphilic cross-linked fatty acid based polymer or derivative. The fatty acid based polymer may include or consist essentially of cross-polymerised repeating units derived from a cross-linkable multi-unsaturated fatty acid based compound or derivative. The fatty acid based polymer may incorporate a diacetylene moiety.

In one embodiment the sealing layer comprises of nanoparticle encapsulated within a self-assembled layer including an amphiphilic cross-linkable diaacetylene based compound or derivative. The diacetylene based compound may incorporate a hydrophilic group, which may be bonded to a terminal carbon atom of the diacetylene compound. The hydrophilic group may be polyethylene glycol or a derivative and or may incorporate polyether linkages. The diacetylene based compound may include a binding group adapted to be able to bind selectively to a target molecule or binding site.

In some embodiments providing the one or more barrier layer(s) includes forming the one or more barrier layer(s), chemical functional groups present on the encapsulation shell of the nanoparticle surface can be used for wide variety of functionalization. For example, the functionalized nanoparticle can be encapsulated by imidazole precursor, and or acryl precursors or silane precursors or combination thereof. In some embodiments a surfactant is added to the sealing mixture.

In another embodiment, graphene nano-sheets or flakes can be encapsulated with monomer or organic species and used as encapsulated nanoparticles described herein. Graphene appears to bond well to the polymers or monomers, allowing a more effective coupling of the graphene. A consideration for creating a graphene suspension is overcoming the enormous van der Waals-like forces between graphite layers to yield a complete exfoliation of graphite flakes and dispersing the resulted graphene sheets stably in a liquid media. Sonication has been extensively used as an exfoliation and dispersion strategy to produce colloidal suspensions of graphene sheets in a liquid phase. This procedure has been successful in various solvents with a surface tension value 40-50 mJ m⁻² which are good media for graphite exfoliation especially with the aid of a third, dispersant phase, such as surfactants and polymers. Herein, ball-milling can be used to exfoliate graphite in a wide variety of organic solvents including ethanol, formamide, acetone, tetrahydrofuran (THF), tetramethyluren (TMU), N,N-dimethylformamide (DMF), and N-methylpyrrolidone (NMP) to create colloidal dispersions of unfunctionalized graphene sheets.

In some embodiments a surface-modifying compound such as a silane is added to the sealing mixture.

According to a fourth aspect, the invention relates to the use of polymer encapsulated reactive nanoparticles for preparing a sealing layer of a barrier stack. The nanoparticles are reactive in that they are capable of interacting with moisture and/or oxygen to retard the permeation of moisture and/or oxygen through the defects present in the barrier layer.

In typical embodiments an encapsulated barrier stack according to the invention has a porous barrier oxide layer, which may for example have been deposited by a Physical Vapor Deposition method and/or by a Chemical Vapor Depositions method. An encapsulated barrier stack according to the invention may further have surface functionalized nanoparticles and/or polymer/monomer encapsulated nanoparticles. These nanoparticles may serve in defining a single layer or multi-layers such as two, three, four or more layers. An encapsulated barrier stack according to the invention has multi-functional properties. The layer(s) of functionalized nanoparticle serve in plugging the defects, increase the tortious path that is available for a fluid (e.g. gas or moisture), block the UV rays, act as thermal barrier, improve anti-reflection and anti-static properties of the barrier stack. In addition, the nanoparticles serve in enhancing thermal barrier properties of the barrier stack.

The one or more nanoparticulate multi-layer(s), e.g. three layers, may be deposited by a slot die coating process in single pass coating (simultaneous multilayer coating method), in some embodiments using a triple slot die or by sequential coating. The nanoparticulate layer, such as a multi-layer, is capable of planarizing the plastic substrates and conformably covering the defects of the plastic films. In addition, it may serve in enhancing the barrier, optical and mechanical properties of the barrier films.

The present invention provides a barrier stack that, being completely or at least substantially devoid of a polymer matrix in which reactive nanoparticles are embedded, comprises an amount of porous polymer that is lower than in known barrier stacks. Known barrier stacks have a polymer interlayer in which the nanoparticles are distributed in the polymer layer/matrix. The polymer may become porous, thereby leading to a pathway for oxygen and moisture and reducing the life time of the devices that are encapsulated by the barrier stack.

"Defects" in the barrier layer refer to structural defects, such as pits, pinholes, microcracks and grain boundaries. Such structural defects are known to exist in all types of barrier layers that are fabricated using deposition processes with which barrier layers are typically produced, such as chemical vapour deposition, as well as roll-to-roll processes. Gases can permeate these defects, thereby leading to poor barrier properties (see Mat. Res. Soc. Symp. Proc. Vol. 763, 2003, B6.10.1-B610.6).

"Reactive" nanoparticles refer to nanoparticles capable of interacting with moisture and/or oxygen, either by way of chemical reaction (e.g. hydrolysis or oxidation), or through physical or physico-chemical interaction (e.g. capillary action, adsorption, hydrophilic attraction, or any other non-covalent interaction between the nanoparticles and water/oxygen). Reactive nanoparticles may comprise or consist of metals which are reactive towards water and/or oxygen, i.e. metals which are above hydrogen in the reactivity series, including metals from Group 2 to 14 (IUPAC) may be used. Some preferred metals include those from Groups 2, 4, 10, 12, 13 and 14. For example, these metals may be selected from Al, Mg, Ba and Ca. Reactive transition metals may also be used, including Ti, Zn, Sn, Ni, and Fe for example.

Other than metals, reactive nanoparticles may also include or consist of certain metal oxides which are capable of interacting with moisture and/or oxygen, such as TiO₂, Al₂O₃, ZrO₂, ZnO, BaO, SrO, CaO and MgO, VO₂, CrO₂, MoO₂, and LiMn₂O₄. In certain embodiments, the metal oxide may comprise a transparent conductive metal oxide selected from the group consisting of cadmium stannate (Cd₂SnO₄), cadmium indate (CdIn₂O₄), zinc stannate (Zn₂SnO₄ and ZnSnO₂), and zinc indium oxide (Zn₂In₂O₅). In some embodiments a reactive nanoparticle may comprise or consist of a metal, a metal oxide, a metal nitride, a metal sulfite, a metal phosphate, a metal carbide and/or a metal oxynitride. Examples of metal nitrides that can be used include, but are not limited to TiN, AIN, ZrN, Zn₃N₂, Ba₃N₂, Sr₃N₂, Ca₃N₂ and Mg₃N₂, VN, CrN or MoN. Examples of metal oxynitrides that can be used include, but are not limited to TiOₓN_{y} such as TiON, AlON, ZrON, Zn₃(N₁₋ₓOₓ)_{2-y}, SrON, VON, CrON, MoON and stoichiometric equivalents thereof. Examples of metal carbides include, but are not limited to, hafnium carbide, tantalum carbide or silicon carbide.

In this conjunction, the person skilled in the art understands that reactivity may depend on the size of the material used (see J. Phys. Chem. Solids 66 (2005) 546-550). For example, Al₂O₃ and TiO₂ are reactive towards moisture in the form of nanoparticles but are unreactive (or reactive only to a very small extent) in the (continuous) bulk phase, such as a microscale or millimetre scale barrier layer which is beyond the nanoscale dimension of several nanometres to several hundred nanometres typically associated with nanoparticles. Accordingly, using Al₂O₃ and TiO₂ as illustrative examples, Al₂O₃ and TiO₂ nanoparticles are considered to be reactive towards moisture, whereas Al₂O₃ and TiO₂ bulk layers are passive barrier layers having low reactivity towards moisture. In general, reactive metal or metal oxide nanoparticles, for example Al₂O₃, TiO₂ or ZnO nanoparticles, may be present in suitable colloidal dispersions for the preservation of reactivity and may be synthesized via any conventional or proprietary method such as the NanoArc® method from Nanophase Technologies Corporation.

Apart from metals and metal oxides, reactive nanoparticles in the sealing layer may also comprise or consist of carbon nanoparticles, such as carbon nanotubes, which are hollow, or nanowires, which are solid. The reactive nanoparticles may also comprise or consist of carbon nanoribbons, nanofibres and any regular or irregular shaped carbon particles with nanoscale dimensions. For carbon nanotubes, single-walled or multi-walled carbon nanotubes may be used. In a study carried out by the present inventors, it was found that carbon nanotubes (CNTs) can serve as a desiccant. Carbon nanotubes can be wetted by low surface tension liquids via capillary action, particularly liquids whose surface tension does not exceed about 200 Nm⁻¹ (Nature, page 801, Vol. 412, 2001). In principle, this would mean that water molecules can be drawn into open-ended carbon nanotubes by capillary suction. It is suggested that water molecules may form quasi-one-dimensional structures within carbon nanotubes, thereby helping to absorb and retain a small volume of oxygen and water molecules. While the quantity of carbon nanotubes may be maximized for maximum moisture and/or oxygen absorption, the inventors have found that in practice lower amounts are also suitable. For example, carbon nanotubes may be used in low quantities of about 0.01% to 10% by weight of the nanoparticles present. Higher concentrations of carbon nanotubes may also be used, but with a corresponding decrease in the transparency of the encapsulation barrier stack.

As further example, the reactive nanoparticles may also be nanofilaments, for example a metal (e.g. a gold or a silver nanowire), a semiconductor (e.g. a silicon or a gallium nitride nanowire) or a polymeric nanoparticle. A further illustrative example is a nanofilament of a metal compound, such as indium phosphide (InP), molybdenum ditelluride (MoTe₂) or Zinc-doped indium phosphide nanowires, molybdenum ditelluride nanotubes. Further examples of nanofilaments of a metal compound include, but are not limited to nanotubes of MoS₂, WS₂, WSe₂, NbS₂, TaS₂, NiCl₂, SnS₂/SnS, HfS₂, V₂O₅, CdS/CdSe and TiO₂. Examples of metal phosphates include, but are not limited to InP and GaP. In one embodiment of a sealing layer, the nanoparticulate metal compound is made of a metal oxide, such as ZnO₂.

The nanoparticles in the sealing layer may also be obtained using a combination of conventional coating methods for the deposition of a seed layer of a metal compound and a solvent thermal method for growing a nanostructure based on the metal compound seeds. The nanostructures obtained by using those methods can be a nanowire, a single-crystal nanostructure, a double-crystal nanostructure, a polycrystalline nanostructure and an amorphous nanostructure.

The nanoparticle, such as a nanowire in the sealing layer may comprise at least one dimension in the range from about 10 nm to 1 µm, e.g. from about 20 nm to about 1 µm, from about 50 nm to about 600 nm, from about 100 nm to about 1 µm, from about 200 nm to about 1 µm, from about 75 nm to about 500 nm, from about 100 nm to about 500 nm, or from about 150 nm to about 750 nm, while another dimension may be in the range from about 200 nm to about 1 µm. Any suitable thickness can be chosen for the nanoparticle sealing layer, for example a thickness of between about 50 nm (for example, when using nanoparticles with a size of about 10 to about 20 nm) to about 1000 nm or even higher (if transparency of the sealing layer is not of concern). The sealing layer may thus have a thickness from about 200 nm to about 10 µm. In another embodiment, the thickness may be from about 200 nm to about 5 µm, or from about 200 nm to about 2 µm or from about 200 nm to about 1 µm, or at least 200 nm.ln other embodiments, the nanoparticle sealing layer may have a thickness of about 250 nm to about 850 nm or of about 350 nm to about 750 nm.

In one embodiment, inert nanoparticles are included in the sealing layer and used in conjunction with reactive nanoparticles. As used herein, "inert nanoparticles" refer to nanoparticles which do not interact at all with moisture and/or oxygen, or which react to a small extent as compared to reactive nanoparticles. Such nanoparticles may be included into the sealing layer to obstruct the permeation of oxygen and/or moisture through the sealing layer. Examples of inert particles include nanoclays as described in US Patent No. 5,916,685. Such nanoparticles serve to plug the defects in the barrier layer, thereby obstructing the path through which permeation takes place, or at least reducing the defect cross-sectional area, thus rendering permeation pathways by which water vapor or oxygen diffuses through the defect much more tortuous, thus leading to longer permeation time before the barrier layer is breached and thereby improving barrier properties.

Other suitable materials for inert nanoparticles may also include unreactive metals such as copper, platinum, gold and silver; minerals or clays such as silica, wollastonite, mullite, monmorillonite; rare earth elements, silicate glass, fluorosilicate glass, fluoroborosilicate glass, aluminosilicate glass, calcium silicate glass, calcium aluminum silicate glass, calcium aluminum fluorosilicate glass, titanium carbide, zirconium carbide, zirconium nitride, silicon carbide, or silicon nitride, metal sulfides, and a mixture or combination thereof.

Encapsulation barrier stacks which comprise sealing layers having only inert nanoparticles, such as nanoclay particles, do not belong to the invention.

In addition the barrier stack may have a terminal layer, which defines a surface of the barrier stack in that it is in contact with the ambience. This terminal layer may comprise or consist of an acrylic polymer. The acrylic polymer may encompass metal halogenide particles. An illustrative example of a metal halogenide is a metal fluoride such as LiF and/or MgF₂.

Without wishing to be bound by theory, the inventors believe that strong barrier properties can be achieved by using a combination of different types of nanoparticles. By studying the absorption/reaction characteristics of different types of nanoparticles, it is possible to select a combination of nanoparticles which complement each other to achieve stronger barrier effects than with a single type of material. For example, different types of reactive nanoparticles may be used in the sealing layer, or a combination of reactive and inert nanoparticles may be used.

In accordance with the above, the sealing layer may include a combination of carbon nanotubes and metal and/or metal oxide nanoparticles. One exemplary embodiment would be the combination of TiO₂/Al₂O₃ nanoparticles with carbon nanotubes. Any range of quantitative ratios may be used and optimized accordingly using regular experimentation. In an exemplary embodiment, the quantity of metal oxide nanoparticles present is between 500 to 15000 times (by weight) the quantity of carbon nanotubes. For oxides of metals having low atomic weight, lower ratios can be used. For example, TiO₂ nanoparticles can be used in combination with carbon nanotubes, with the weight ratio of carbon nanotubes to TiO₂ being between about 1 : 10 to about 1 : 5, but not limited thereto.

The encapsulation barrier stack of the invention may be used to encapsulate any type of moisture and/or oxygen sensitive article, such as electronic devices, drugs, foods, and reactive materials, for example. For encapsulating electroluminescent devices, the quality of light transmitted through the encapsulation barrier stack is particularly important. Thus, when the encapsulation barrier stack is used as a cover substrate over a top-emitting OLED, or when the encapsulation layer is designed for transparent OLED or see-through displays, the encapsulation barrier stack should not cause the quality of light transmitted by the electroluminescent device to be substantially degraded.

Based on the above requirement, the size of the particles may be chosen in such a way that optical transparency is maintained. In one embodiment, the sealing layer comprises nanoparticles having an average size of less than 1/2, or more preferably less than 1/5, the characteristic wavelength of light produced by the electroluminescent electronic component. In this context, the characteristic wavelength is defined as the wavelength at which the peak intensity of the light spectrum that is produced by the electroluminescent device. For electroluminescent devices emitting visible light, this design requirement translates into nanoparticles having a dimension of less than about 350 nm, or more preferably less than 200 nm.

As the random packing density of nanoparticles in the defects of the barrier layer is determined by the shape and size distribution of the nanoparticles, it is advantageous to use nanoparticles of different shapes and sizes to precisely control the sealing of defects of the barrier oxide layer. The nanoparticles may be present in one uniform shape or it may be formed in two or more shapes. Possible shapes that the nanoparticles can assume include spherical shapes, rod shapes, elliptical shapes or any irregular shapes. In the case of rod shaped nanoparticles, they may have a diameter of between about 10 nm to 50 nm, a length of 50 to 400 nm, and an aspect ratio of more than 5, but not limited thereto.

In order to provide efficient interaction between the reactive nanoparticles and the water vapour/oxygen permeating the barrier layer, the nanoparticles occupying the defects may have suitable shapes that would maximize the surface area that can come into contact with the water vapour and oxygen. This means that the nanoparticles may be designed to have a large surface area to volume, or surface area to weight ratio. In one embodiment, the nanoparticles have a surface area to weight ratio of between about 1 m²/g to about 200 m²/g. This requirement can be achieved by using nanoparticles with different shapes, such as two, three, four or more different shapes as described above.

A binder in which the nanoparticles are distributed may optionally be used in the sealing layer. Materials suitable for use as the binder include polymers, such as polymers derivable from monomers having at least one polymerisable group, and which can be readily polymerised. Examples of polymeric materials suitable for this purpose include polyacrylate, polyacrylamide, polyepoxide, parylene, polysiloxanes and polyurethane or any other polymer. For strong adhesion between two successive barrier layers, or to adhere the multilayer film onto a substrate, the polymers with good adhesive quality may be chosen. The sealing layer containing the nanoparticles is typically formed by coating the barrier with a dispersion containing nanoparticles mixed with a monomer solution, e.g. an unsaturated organic compound having at least one polymerisable group. The thickness of the sealing layer comprising binder with distributed nanoparticles therein can be in the range of about 2 nm to about several micrometers.

A sealing layer of a multilayer film in a barrier stack of the invention is designed to be capable of contacting at least a portion of the surface of a barrier layer. A sealing layer may for example be capable of contacting at least 50 %, at least 60 %, at least 70 %, at least 75 %, at least 80 %, at least 85 %, at least 90 %, at least 92 %, at least 95 %, at least 96 %, at least 97 %, at least 98 %, at least 99 %, at least 99.5 % or 100 % of the surface of the barrier layer.

In some embodiments, the sealing layer is arranged to be in close proximate contact with the entire surface of the barrier layer. For example, the sealing layer may be formed over the barrier layer in such a manner that it conforms to the shape of defects present on the surface of the barrier layer, i.e. either occupying or filling up entirely the pits present in the at least one barrier layer, or levelling rough protrusions over the surface of the barrier layer. In this manner, defects giving rise to the permeation of corrosive gases through the encapsulation barrier stack are "plugged", while protrusions which would otherwise give rise to poor interfacial contact between barrier layers are levelled. Any conformal coating or deposition method can be used, e.g. chemical vapour deposition or spin coating. Atomic layer deposition and pulsed laser deposition may also be used to form the sealing layer.

The barrier material used for forming the barrier layer of the multilayer film may comprise any typical barrier material with low permeability to water vapour and/or oxygen in the bulk phase. For example, the barrier material may comprise metals, metal oxides, ceramics, inorganic polymers, organic polymers and combinations thereof. In one embodiment, the barrier material is selected from indium tin oxide (ITO), TiAIN, SiO₂, SiC, Si₃N₄, TiO₂, HfO₂, Y₂O₃, Ta₂O₅, and Al₂O₃. The thickness of a barrier layer may be between 20 nm to 80 nm. In this respect, materials for reactive nanoparticles can be used as the barrier layer since the reactivity of the material depends on its size. For example, although nanoparticulate Al₂O₃ is reactive towards water, a bulk layer of Al₂O₃ which has larger than nanoscale dimensions does not display the same level of reactivity with water, and can thus be used for the barrier layer.

For certain applications which require the encapsulation barrier stack to have good mechanical strength, a substrate may be provided to support the multilayer film. The substrate may be flexible or rigid. The substrate may comprise any suitable variety of materials such as polyacetate, polypropylene, polyimide, cellophane, poly(1-trimethylsilyl-1-propyne, poly(4-methyl-2-pentyne), polyimide, polycarbonate, polyethylene, polyethersulfone, epoxy resins, polyethylene terephthalate, polystyrene, polyurethane, polyacrylate, polyacrylamide, polydimethylphenylene oxide, styrene-divinylbenzene copolymers, polyvinylidene fluoride (PVDF), nylon, nitrocellulose, cellulose, glass, indium tin oxide, nano-clays, silicones, polydimethylsiloxanes, biscyclopentadienyl iron, or polyphosphazenes, to name some illustrative examples. The base substrate may be arranged to face the external environment or it may face the encapsulated environment. In food packaging, the substrate may face the internal surface that is in contact with food while the encapsulation barrier stack forms the external surface in contact with atmospheric conditions.

Although it may be possible to form a multilayer film directly on a substrate, a substrate with a rough surface may be undesirable for direct contact with the barrier layer of the multilayer film. An interface layer between the multilayer film and the substrate may be provided to improve the contact between them. In one embodiment, a planarising layer is interposed between the substrate and the multilayer film so that the interface between the substrate and the multilayer film is improved. The planarising layer may include any suitable type of polymeric adhesive material such as epoxy. In one embodiment, the planarising layer comprises polyacrylate (acrylic polymer), as polyacrylate is known for having strong water absorption properties. In the absence of a planarising layer, the multilayer film may be orientated such that the sealing layer is in contact with the surface of the substrate, for example.

Typically an encapsulation barrier stack according to the invention has a water vapor transmission rate of less than about 10⁻³ g/m²/day, less than about 10⁻⁴ g/m²/day, less than about 1 x 10⁻⁵ g/m²/day such as less than about 0.5 x 10⁻⁵ g/m²/day, less than about 1 x 10⁻⁶ g/m²/day or less than about 0.5 x 10⁻⁶ g/m²/day.

The barrier effect of a single barrier layer coupled with a sealing layer, i.e. a single 'paired layer', is additive, meaning that the number of pairs of barrier/sealing layers coupled together is proportional to the overall barrier property of the multilayer film. Accordingly, for applications requiring high barrier properties, a plurality of paired layers may be used. In one embodiment, a barrier layer is arranged, e.g. stacked, on top of a sealing layer in alternating sequence. In other words, each sealing layer acts as an interface layer between 2 barrier layers. In some embodiments, 1, 2, 3, 4, or 5 paired layers are present in the multilayer film. For general purpose applications in which water vapour and oxygen transmission rates are less stringent (e.g. less than 10⁻³ g/m²/day), the multilayer film may include only 1 or 2 barrier layers (1, 2 or 3 sealing layers would correspondingly be present), whereas for more stringent applications, 3, 4, 5 or more barrier layers may be included in the multilayer film to achieve water vapour transmission rates of less than 10⁻⁵ g/m²/day or preferably less than 10⁻⁶ g/m²/day. Where more than 2 paired layers are used, any combination of paired layers may be formed on opposing sides of the substrate to provide a double-laminated or deposited on to the substrate, or they be formed on the same side of the substrate.

In order to protect the multilayer film from mechanical damage, the multilayer film may be capped or overlaid with a terminal protective layer. The terminal layer may comprise any material having good mechanical strength and is scratch resistant. In one embodiment, the terminal layer comprises an acrylic film having distributed therein LiF and/or MgF₂ particles. In another embodiment, the terminal layer comprises an oxide film such as Al₂O₃ or any inorganic oxide layers.

The encapsulation barrier stack according to the invention may be used for any suitable barrier application, such as in the construction of a casing or housing, or a barrier foil for blister packs, or it may be used as an encapsulating layer over an electronic component. The encapsulation barrier stack may also be laminated or deposited over any existing barrier material, such as packaging materials for food and drinks, to improve their existing barrier properties. In a preferred embodiment, the encapsulation barrier stack is used to form an encapsulation for protecting electroluminescent electronic components comprising moisture and/or oxygen sensitive reactive layers, wherein the electroluminescent component is encapsulated within the encapsulation. Examples of such devices include, but are not limited to, reactive components comprised in Organic Light Emitting Devices (OLEDs), flexible solar cells, thin film batteries, charged-coupled devices (CCDs), or micro-electromechanical sensors (MEMS).

In OLED applications, the encapsulation barrier stack may be used to form any part of an encapsulation for isolating the active component of the OLED device. In one embodiment, the encapsulation barrier stack is used to form a base substrate for supporting the reactive layers of the electroluminescent component. In a rim-sealing structure, the encapsulation barrier stack may be used to form a rigid cover that is arranged over the reactive layers of the electroluminescent component. The rigid cover may be attached to the base substrate by means of an adhesive layer, the adhesive layer being arranged at least substantially along the edge of the cover substrate for forming an enclosure around the reactive component. In order to minimize lateral diffusion of oxygen/moisture into the enclosure containing the reactive component, the width of the covering layer or the adhesive layer may be made larger than the thickness of the encapsulation barrier stack. The term "covering layer" used herein refers to any layer that covers the barrier stack, meaning the cover layer is different from the sealing layer. The cover layer can, for example, be a protection layer that provides protection for the barrier stack from mechanical wear and tear (abrasion) or chemical or physical-chemical environmental influences (humidity, sunlight etc.).

In another embodiment, the encapsulation barrier stack is used to form a flexible encapsulating layer which seals the electroluminescent component against the base substrate. In this case, such an encapsulating layer may wrap around the surface of the electroluminescent component to form a 'proximal encapsulation'. The shape of the encapsulating layer thus conforms to the shape of the reactive component, leaving no gap between the electroluminescent component to be encapsulated and the encapsulating layer.

The present invention is further directed to a method of forming an encapsulation barrier stack according to the invention. The method comprises forming at least one barrier layer and at least one sealing layer. As the sealing layer contains reactive nanoparticles, steps involving the preparation and the use of the sealing layer are preferably carried out under vacuum to preserve the reactivity of the nanoparticles towards the moisture and/or oxygen. The step of forming the sealing layer may comprise mixing a polymerisable compound with a nanoparticle dispersion to form a sealing mixture, and polymerising the sealing mixture after being applied on the barrier layer under vacuum to form a sealing layer. The nanoparticle dispersion may comprise nanoparticles dispersed in at least one organic solvent. The at least one organic solvent may include any suitable solvent, such as ethers, ketones, aldehydes and glycols for example.

Nanoparticles may be synthesized by any conventional method known in the art, including vapor phase synthesis (Swihart, Current Opinion in Colloid and Interface Science 8 (2003) 127-133), sol-gel processing, sonochemical processing, cavitation processing, microemulsion processing, and high-energy ball milling, for instance. Nanoparticles are also commercially available either as nanoparticle powders or in a ready-made dispersion from Nanophase Technologies Corporation, for example. Proprietary methods may be used to synthesize commercially obtained nanoparticles such as NanoArc® synthesis.

In one embodiment, surface-activation of the nanoparticles is carried out in order to remove contaminants from the surface of the nanoparticles that may interfere with their ability to react with moisture and/or oxygen. Surface activation may comprise treating the nanoparticles with an acid, including a mineral acid such as hydrochloric acid or sulphuric acid. In some embodiments the acid used for said treatment is a dilute acid. Treatment comprises immersing the nanoparticles in the acid for a period of about 1 hour. It is to be noted that nanoparticles which can be easily contaminated such as carbon nanotubes and carbon nanofibres may require surface activation. On the other hand, nanoparticles such as aluminium oxide and titanium oxide may not require surface activation since these nanoparticles have high surface energy.

The polymerisable compound may be any readily polymerisable monomer or pre-polymer. Suitable monomers are preferably readily polymerisable via UV curing or heat curing or any other convenient curing method.

In one embodiment, polyacrylamide is used as polymer for binding the nanoparticles. Acrylic acid monomer powder may be dissolved in polar organic solvents such as 2-methoxyethanol (2MOE) and ethylene glycol (EG) or isopropyl alcohol and ethyl acetate. In order to obtain a uniform distribution of the nanoparticles in the sealing mixture, sonification of the sealing mixture may additionally be carried out. For instance, sonification may be carried out for at least about 30 minutes prior to polymerisation.

A substrate may be a part of the device to be encapsulated, such as a part of a circuit board, or it may be an additional structure that is included as part of the encapsulation, such as a flexible substrate. It is also possible that the substrate is part of the encapsulation barrier stack, comprising a thick barrier layer on which further sealing layers arid barrier layers are subsequently deposited. Otherwise, the substrate may be the surface of a worktop for fabricating the multilayer film and as such does not form part of the encapsulation barrier stack.

Once the substrate has been provided, it can be coated with barrier layers and the sealing solution. The barrier layer can be formed via physical vapor deposition (e.g. magnetron sputtering, thermal evaporation or electron beam evaporation), plasma polymerization, CVD, printing, spinning or any conventional coating processes including tip or dip coating processes.

The sealing solution may be formed on the barrier layer via any wet process method such as spin coating, screen printing, WebFlight method, tip coating, CVD methods or any other conventional coating methods. Metal oxide and metal nano-particles, as well as carbon nanotubes, can be co-deposited through the wet-coating process or co-evaporated along with monomer or dimers of parylene based polymer films. Any type of parylene dimers including parylene C or D or any other grades can be evaporated along with nano particles.

If multiple barrier/sealing layers, i.e. paired layers, are to be formed, a substrate can be repetitively coated with the barrier material and sealing mixture (see also below). In order to establish an alternating arrangement comprising one or more successive barrier layers and sealing layers, the substrate may be successively coated first with the barrier material and then the sealing solution repeating over several times until the intended number of layers is formed. Each time the sealing solution is applied, it is cured, for example UV cured prior to the formation of the next barrier layer over it. In this context, it is noted that a barrier layer can be coated with two or more functional sealing layers. Therefore, a barrier stack of the invention may not be an alternating order of one barrier layer coated with one sealing layer. Rather, a barrier stack might consist of only one barrier layer on which one, two, three, four or even more functional sealing layers are deposited. Alternatively, if the barrier stack comprises more than one barrier layer, each barrier layer might be coated with one or more sealing layers. For example, one barrier layer might have only one sealing layer coated thereon, whereas a second or third barrier layer of the barrier stack might have two or more sealing layers arranged on the respective barrier layer.

After the sealing and barrier layers have been formed, optional steps may be taken to complete the construction of the encapsulation barrier stack, such as the formation of a glass cover, ITO lines and ITO coating. For example, Passive Matrix displays may require ITO lines to be formed on the encapsulation barrier stack. After the cover has been formed, the exposed surface of the cover may be further protected with a protective coating via deposition of a capping layer (MgF/LiF coating).

These aspects of the invention will be more fully understood in view of the following description, drawings and non-limiting examples.

### BRIEF DESCRIPTION OF THE DRAWINGS

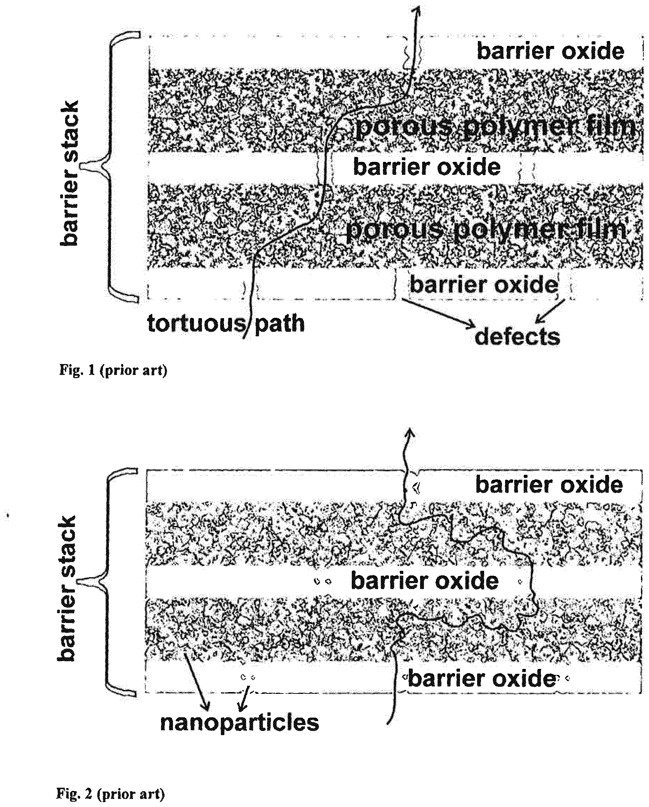

**Figure 1** depicts a known barrier stack device, in which the barrier oxide coating defects are decoupled by an intermediate polymer layer. The tortuous path, i.e. the permeation path for fluid or the time taken to diffuse through the barrier depends on the number of inorganic/organic pairs used. If a higher number of the pairs are used, the path is longer and therefore, higher barrier properties can be achieved. Using multiple barrier layers, the overall performance will vary depending on whether the pinholes in one barrier layer are lined up with the defects in the other barrier layers or not. In addition, if the numbers of defects are higher, the decoupling concept will not work. In the sense, the defects of the barrier layer may be lined up with the defects in the second barrier layer. This invention requires very high packing density (lower number of pin holes) barrier oxide films, which are produced either by sputtering methods or PECVD methods.
**Figure 2** depicts a further known barrier stack device disclosed in WO 2008/057045 and WO2010/140980, in which nanoparticles are distributed in the polymer matrix to improve the barrier properties. These disclosures are not concerned with sealing barrier oxide film defects. A drawback of the device shown in Fig. 2 is that water vapor will be released through the pinholes of the barrier oxide films once the reactive nanoparticles are saturated with water vapor. Further, there is a limitation in loading the nanoparticles in the thermoplastics (the base film normally formed by extrusion process where in the thermoplastic melts, the films are drawn and then cooled down), it is a complex process and a higher number of getter nanoparticles loading in the film would affect the transmittance.
**Figure 3A** depicts an embodiment of a barrier stack according to the invention.
**Figure 3B** depicts a further embodiment of a barrier stack according to the invention.
**Figure 3C** depicts yet another embodiment of a barrier stack according to the invention, deposited onto a planarized or non-planarized substrate that is of plastic material.
**Figure 4** illustrates a qualitative test on barrier stack performance, analysing whether calcium degradation can occur (Type A).
**Figure 5** illustrates a quantitative test on barrier stack performance, analysing calcium degradation (Type B).
**Figure 6** depicts a nanogetter layer coated polycarbonate substrate.
**Figure 7** shows an SEM picture depicting the surface topography of polymer encapsulated nanoparticles at 20.000 x magnification.
**Figure 8** shows an SEM picture depicting the surface topography of polymer encapsulated nanoparticles at 45.000 x magnification.
**Figure 9** shows an SEM picture of plain anodisc® with 200nm pinholes before coating at 10,000x magnification.
**Figure 10** shows an SEM picture of encapsulated nanoparticles coated (4 micron coating thickness) onto the anodisc® (as shown in Fig. 9) in cross section at 13,000 x magnification.
**Figure 11** depicts an SEM picture of the bottom side of anodisc®, which was coated with a layer of polymer encapsulated nanoparticles shown at a magnification of 10,000. The disk was peeled off from the plastic substrate, thus showing the defects sealing mechanism.
**Figure 12** shows a TEM image illustrating that the nanoparticles are distributed in the polymer layer/film (50nm scale).
**Figure 13A** shows a SEM image of the distribution of aluminum oxide nanoparticles in a polymer matrix as known in the art at 35.000 x magnification. **Figure 13B** shows a SEM image of prior art aluminium oxide nanoparticles before encapsulation at 70.000 x magnification. **Figure 13C** shows a SEM image of the polymer encapsulated nanoparticles of the invention at 100.000 x magnification and **Figure 13D** shown a SEM image of a layer of polymer encapsulated nanoparticles.
**Figure 14A** and **Figure 14B** depict the results of a standard test method for peel resistance. The ASTM peel test optical images show no delamination of the polymer encapsulated nanoparticle layer - aluminium oxide - interfaces.
**Figure 15** shows an illustration of polymer encapsulated nanoparticles and with polymer passivated particles as used in the invention, with Figures 15A and 15B showing a partially encapsulated (i.e. a passivated) nanoparticle and Figure 15C showing a completely encapsulated nanoparticle.
**Figure 16A** **and** **Figure 16B** show SEM images of a cross section of a barrier stack of the invention at 50.000 x magnification having a sealing layer of polymer encapsulated nanoparticles, deposited on an oxide layer which in turn is arranged on a PET plastic substrate.
**Figure 17** shows a SEM image of a cross section of a barrier stack of the invention at 30.000 x magnification having a sealing layer of polymer encapsulated nanoparticles, deposited on an oxide layer which in turn is arranged on a PET plastic substrate.

### DETAILED DESCRIPTION OF THE INVENTION

**FIG. 3C** shows one embodiment of an encapsulation barrier stack according to the invention, which is in addition arranged on a plastic substrate. The encapsulation barrier stack comprises a multilayer film. The multilayer film comprises one or more barrier layers and one or more sealing layers. The multilayer film may for example include one, two, three, four, five, six, seven, eight nine or ten barrier layers. The multilayer film may for example include one, two, three, four, five, six, seven, eight nine or ten sealing layers. In embodiments with a plurality of barrier layers and sealing layers individual barrier layers and sealing layers may be in contact with other barrier layers and/or sealing layers. In some embodiments an individual barrier layer is in contact with two further barrier layers. In some embodiments an individual barrier layer is in contact with two sealing layers. In some embodiments an individual barrier layer is in contact with one further barrier layer and one sealing layer. In some embodiments an individual sealing layer is in contact with two further sealing layers. In some embodiments an individual sealing layer is in contact with two barrier layers. In some embodiments an individual sealing layer is in contact with one further sealing layer and one barrier layer. In some embodiments two or more sealing layers and one or more barrier layer(s) of the multilayer film are arranged in an alternating manner. In some embodiments the multilayer film includes a plurality of sealing layers and barrier layers arranged in an alternating sequence. In the embodiment depicted in **Fig. 3C** one barrier layer is present, denominated the barrier oxide. In the embodiment depicted in **Fig. 3C** two sealing layers are present, each denominated a functional nano layer. As noted above, it is also the scope of the present invention that each barrier layer has a different number of sealing layers arranged thereon. In it also in the scope of the invention that in case of a barrier stack with more than one sealing layers, only the sealing layer that directly contacts the barrier layer comprises or consists of polymer encapsulated nanoparticles of the invention and that other layers can be a sealing layer of the prior art, for example, a sealing layer as described in WO 2008/057045 in which reactive nanoparticles are distributed in a polymer matrix. The barrier layers have low permeability to oxygen and/or moisture. It will be noted that barrier layers contain pinhole defects which extend through the thickness of the barrier layer. Pinhole defects along with other types of structural defects limit the barrier performance of barrier layers as oxygen and water vapour can permeate into the barrier layer via these defects, eventually traversing the encapsulation barrier stack and coming into contact with the oxygen/moisture sensitive device.

The sealing layer(s) comprise(s) reactive nanoparticles capable of interacting with water vapour and/or oxygen, thereby retarding the permeation of oxygen/moisture through the encapsulation barrier stack. In accordance with the present invention, these defects are at least partially covered up, or in some embodiments, entirely filled up by the nanoparticles in the sealing layer. The nanoparticles are polymer encapsulated. Examples of suitable polymers include, but are not limited to, polypropylene, polyisoprene, polystyrene, polyvinyl chloride, polyisobutylene, polyethylene terephthalate (PET), polyacrylates (e.g. polymethyl-methacrylate (PMMA)), ethylene-vinyl acetate (EVA) copolymers, phenol formaldehyde resins, epoxy resins, poly(N-propargylamides), poly(O-propargylesters), and polysiloxanes.

The monomer or the pre-polymer that is used for the encapsulation of the reactive nanoparticles (and that is typically included in a non-aqueous based discontinuous phase solution for the preparation of the sealing layer) may be selected from any suitable hydrophobic material. Illustrative examples of hydrophobic monomers include, but are not limited to, styrenes (e.g., styrene, methylstyrene, vinylstyrene, dimethylstyrene, chlorostryene, dichlorostyrene, tert-butylstyrene, bromostyrene, and p-chloromethylstyrene), monofunctional acrylic esters (e.g., methyl acrylate, ethyl acrylate, isopropyl acrylate, n-butyl acrylate, butoxyethyl acrylate, isobutyl acrylate, n-amyl acrylate, isoamyl acrylate, n-hexyl acrylate, octyl acrylate, decyl acrylate, dodecyl acrylate, octadecyl acrylate, benzyl acrylate, phenyl acrylate, phenoxyethyl acrylate, cyclohexyl acrylate, dicyclopentanyl acrylate, dicyclopentenyl acrylate, dicyclopentenyloxyethyl acrylate, tetrahydrofurfuryl acrylate, isobornyl acrylate, isoamyl acrylate, lauryl acrylate, stearyl acrylate, benhenyl acrylate, ethoxydiethylene glycol acrylate, methoxytriethylene glycol acrylate, methoxydipropylene glycol acrylate, phenoxypolyethylene glycol acrylate, nonylphenol EO adduct acrylate, isooctyl acrylate, isomyristyl acrylate, isostearyl acrylate, 2-ethylhexyl diglycol acrylate, and oxtoxypolyethylene glycol polypropylene glycol monoacrylate), monofunctional methacrylic esters (e.g., methyl methacrylate, ethyl methacrylate, isopropyl methacrylate, n-butyl methacrylate, i-butyl methacrylate, tert-butyl methacrylate, n-amyl methacrylate, isoamyl methacrylate, n-hexyl methacrylate, 2-ethylhexyl methacrylate, lauryl methacrylate, tridecyl methacrylate, stearyl methacrylate, isodecyl methacrylate, octyl methacrylate, decyl methacrylate, dodecyl methacrylate, octadecyl methacrylate, methoxydiethylene glycol methacrylate, polypropylene glycol monomethacrylate, benzyl methacrylate, phenyl methacrylate, phenoxyethyl methacrylate, cyclohexyl methacrylate, tetrahydrofurfuryl methacrylate, tert-butylcyclohexyl methacrylate, behenyl methacrylate, dicyclopentanyl methacrylate, dicyclopentenyloxyethyl methacrylate, and polypropylene glycol monomethacrylate), allyl compounds (e.g., allylbenzene, allyl-3-cyclohexane propionate, 1-allyl-3,4-dimethoxybenzene, allyl phenoxyacetate, allyl phenylacetate, allylcyclohexane, and allyl polyvalent carboxylate), unsaturated esters of fumaric acid, maleic acid, itaconic acid, etc., and radical polymerizable group-containing monomers (e.g., N-substitued maleimide and cyclic olefins).

In one embodiment, the polymer-encapsulated nanoparticles may be formed in a non-water-based solution (sealing mixture). In this embodiment, the monomers may be selected from acid containing radical polymerizable monomers.

In another embodiment, the polymer-encapsulated nanoparticles may be formed in the sealing mixture of an acid containing radical polymerizable monomers. In this embodiment, the monomer may be selected from acrylic acid, methacrylic acid, acrylamides, methacrylamides, hydroxyethyl-methacrylates, ethylene-oxide-base methacrylates, and combinations thereof.

In another embodiment, the polymer-encapsulated nanoparticle may be formed in a sealing mixture wherein pre-polymers are used. Such pre-polymers might be selected from an acrylic oligomer having a molecular weight less than about 1000 Da and a viscosity less than about 300 cPoise.

In some embodiments the one or more sealing layer(s) at least essentially consist(s) of the polymer encapsulated reactive nanoparticles. The term "at least essentially consisting of" means that the respective layer is generally free of other matter, as judged by standard analytical techniques. The layer may contain minor amounts of other matter, but it may also be entirely free of other matter, at least as judged by known analytical techniques. Thus, the one or more sealing layer(s) may consist(s) only of the polymer encapsulated reactive nanoparticles. A portion of the plurality of polymer encapsulated nanoparticles or all polymer encapsulated nanoparticles may have an aliphatic, alicyclic, aromatic or arylaliphatic compound immobilized thereon. The aliphatic, alicyclic, aromatic or arylaliphatic compounds have a polar group. The polar group may, for example, be a hydroxyl group, a carboxyl group, a carbonyl group, an amino group, an amido group, a thio group, a seleno group, and a telluro group.

The term "aliphatic" means, unless otherwise stated, a straight or branched hydrocarbon chain, which may be saturated or mono- or poly-unsaturated and include heteroatoms (see below). An unsaturated aliphatic group contains one or more double and/or triple bonds (alkenyl or alkinyl moieties). The branches of the hydrocarbon chain may include linear chains as well as non-aromatic cyclic elements. The hydrocarbon chain, which may, unless otherwise stated, be of any length, and contain any number of branches. Typically, the hydrocarbon (main) chain includes 1 to 5, to 10, to 15 or to 20 carbon atoms. Examples of alkenyl radicals are straight-chain or branched hydrocarbon radicals which contain one or more double bonds. Alkenyl radicals normally contain about two to about twenty carbon atoms and one or more, for instance two, double bonds, such as about two to about ten carbon atoms, and one double bond. Alkynyl radicals normally contain about two to about twenty carbon atoms and one or more, for example two, triple bonds, such as two to ten carbon atoms, and one triple bond. Examples of alkynyl radicals are straight-chain or branched hydrocarbon radicals which contain one or more triple bonds. Examples of alkyl groups are methyl, ethyl, propyl, butyl, pentyl, hexyl, heptyl, octyl, nonyl, decyl, the n isomers of these radicals, isopropyl, isobutyl, isopentyl, sec-butyl, tert-butyl, neopentyl, 3,3-dimethylbutyl. Both the main chain as well as the branches may furthermore contain heteroatoms as for instance N, O, S, Se or Si or carbon atoms may be replaced by these heteroatoms.

The term "alicyclic" means, unless otherwise stated, a non-aromatic cyclic moiety (e.g. hydrocarbon moiety), which may be saturated or mono-or poly-unsaturated. The cyclic hydrocarbon moiety may also include fused cyclic ring systems such as decalin and may also be substituted with non-aromatic cyclic as well as chain elements. The main chain of the cyclic hydrocarbon moiety may, unless otherwise stated, be of any length and contain any number of non-aromatic cyclic and chain elements. Typically, the hydrocarbon (main) chain includes 3, 4, 5, 6, 7 or 8 main chain atoms in one cycle. Examples of such moieties include, but are not limited to, cylcopentyl, cyclohexyl, cycloheptyl, or cyclooctyl. Both the cyclic hydrocarbon moiety and, if present, any cyclic and chain substituents may furthermore contain heteroatoms, as for instance N, O, S, Se or Si, or a carbon atom may be replaced by these heteroatoms. The term "alicyclic" also includes cycloalkenyl moieties that are unsaturated cyclic hydrocarbons, which generally contain about three to about eight ring carbon atoms, for example five or six ring carbon atoms. Cycloalkenyl radicals typically have a double bond in the respective ring system. Cycloalkenyl radicals may in turn be substituted.

The term "aromatic" means, unless otherwise stated, a planar cyclic hydrocarbon moiety of conjugated double bonds, which may be a single ring or include multiple fused or covalently linked rings, for example, 2, 3 or 4 fused rings. The term aromatic also includes alkylaryl. Typically, the hydrocarbon (main) chain includes 5, 6, 7 or 8 main chain atoms in one cycle. Examples of such moieties include, but are not limited to, cylcopentadienyl, phenyl, napthalenyl-, [10]annulenyl-(1,3,5,7,9-cyclodecapentaenyl-), [12]annulenyl-, [8]annulenyl-, phenalene (perinaphthene), 1,9-dihydropyrene, chrysene (1,2-benzophenanthrene). An example of an alkylaryl moiety is benzyl. The main chain of the cyclic hydrocarbon moiety may, unless otherwise stated, be of any length and contain any number of heteroatoms, as for instance N, O and S. Examples of such heteroarom containing moieties (which are known to the person skilled in the art) include, but are not limited to, furanyl-, thiophenyl-, naphtyl-, naphthofuranyl-, anthraxthiophenyl-, pyridinyl-, pyrrolyl-, quinolinyl, naphthoquinolinyl-, quinoxalinyl-, indolyl-, benzindolyl-, imidazolyl-, oxazolyl-, oxoninyl-, oxepinyl-, benzoxepinyl-, azepinyl-, thiepinyl-, selenepinyl-, thioninyl-, azecinyl- (azacyclodecapentaenyl-), diazecinyl-, azacyclododeca-1,3,5,7,9,11-hexaene-5,9-diyl-, azozinyl-, diazocinyl-, benzazocinyl-, azecinyl-, azaundecinyl-, thia[11]annulenyl-, oxacyclotrideca-2,4,6,8,10,12-hexaenyl- or triazaanthracenyl-moieties.

By the term "arylaliphatic" is meant a hydrocarbon moiety, in which one or more aromatic moieties are substituted with one or more aliphatic groups. Thus the term "arylaliphatic" also includes hydrocarbon moieties, in which two or more aryl groups are connected via one or more aliphatic chain or chains of any length, for instance a methylene group. Typically, the hydrocarbon (main) chain includes 5, 6, 7 or 8 main chain atoms in each ring of the aromatic moiety. Examples of arylaliphatic moieties include, but are not limited, to 1-ethyl-naphthalene, 1,1'-methylenebis-benzene, 9-isopropylanthraxcene, 1,2,3-trimethyl-benzene, 4-phenyl-2-buten-1-ol, 7-chloro-3-(1-methylethyl)-quinoline, 3-heptyl-furan, 6-[2-(2,5-diethylphenyl)ethyl]-4-ethyl-quinazoline or, 7,8-dibutyl-5,6-diethyl-isoquinoline.

Each of the terms "aliphatic", "alicyclic", "aromatic" and "arylaliphatic" as used herein is meant to include both substituted and unsubstituted forms of the respective moiety. Substituents my be any functional group, as for example, but not limited to, amino, amido, azido, carbonyl, carboxyl, cyano, isocyano, dithiane, halogen, hydroxyl, nitro, organometal, organoboron, seleno, silyl, silano, sulfonyl, thio, thiocyano, trifluoromethyl sulfonyl, p-toluenesulfonyl, bromobenzenesulfonyl, nitrobenzenesulfonyl, and methane-sulfonyl.

In some embodiments the at least one sealing layer conforms substantially to the shape of the defects present on the surface of the at least one barrier layer. The sealing layer may act as a planarising material that smoothens the surface of the substrate, thereby covering defects on the substrate which could provide pathways for the infiltration of moisture/oxygen. In this regard, application of a sealing layer above a barrier layer may further allow smoothening the surface in case further barrier layers are intended to be deposited on the barrier film.

The preceding embodiments relate to an encapsulation barrier stack in which the multilayer film is immobilized, e.g. laminated onto only one side of a substrate. In some embodiments a barrier stack is immobilized on a double-laminated substrate in which a multilayer film is laminated or deposited on to two sides, which may be opposing sides, of a base substrate. An encapsulation barrier stack may for instance include a substrate that is sandwiched between two multilayer films.

As will be apparent from the above, a multilayer film according to the invention has at least two layers, a barrier layer and a sealing layer, each of which has an upper face and a lower face, defining a plane. Each layer further has a circumferential wall defining a thickness of the layer. Typically each layer is of at least essentially uniform thickness. In some embodiments the circumference of each layer is of at least essentially the same dimensions as the circumference of any other layer. A multilayer film according to the invention has two (upper and lower) outer surfaces defined by the upper face of a first layer and the lower face of a second layer. These two surfaces are arranged on at least essentially opposing sides of the multilayer film. Each of these two surfaces defines a plane. In typical embodiments these two planes are essentially parallel to each other. Furthermore these two surfaces are exposed to the ambience. Typically one or both of these planes is/are adapted for being contacted with the surface of a substrate, including for being immobilized thereon. In some embodiments the surface topology of the respective surface of the multilayer film is at least essentially matching, e.g. at least essentially congruent to, the surface topology of the plane of the substrate.

The encapsulation barrier stack of the invention can be used in several ways for encapsulating a moisture and oxygen sensitive device. Any device may be encapsulated by an encapsulation barrier stack of the invention, such as an OLED, pharmaceutical drugs, jewellery, reactive metals, electronic components or food substances. For example, it can be arranged, for example laminated or deposited, onto a conventional polymer substrate that is used to support the OLED. As explained above, pinhole defects in the barrier layer are sealed by the polymer encapsulated nanoparticulate material of the sealing layer. The OLED may be arranged directly on the multilayer film, and for instance encapsulated under a cover such as a glass cover, for instance using rim sealing or thin-film encapsulation comprising the attachment of an encapsulation barrier stack over the OLED, hereinafter referred to as 'proximal encapsulation', is also possible. Proximal encapsulation is in particular suitable for flexible OLED devices. In such an embodiment the multilayer film of the encapsulation barrier stack conforms to the external shape of the OLED device.

An encapsulation barrier stack according to the invention may be produced by forming on one or more barrier layer(s), on a substrate or on a (further) sealing layer, a sealing layer. In some embodiments the sealing layer may be formed on a substrate. The sealing layer may be formed by mixing a polymerisable compound with a plurality of reactive nanoparticles as defined above. The plurality of nanoparticles may in some embodiments be a colloidal dispersion comprising nanoparticles dispersed in a suitable liquid such as an organic solvent. In some embodiments a polar solvent such as e.g. ethanol, acetone, N,N-dimethyl-formamide, isopropanol, ethyl acetate or nitromethane, or a non-polar organic solvent such as e.g. benzene, hexane, dioxane, tetrahydrofuran or diethyl ether (cf. also below). As explained above, in order to allow for encapsulation of the reactive nanoparticles, the polymerisable compound (which might be a monomeric compound) is present in such a low concentration in the sealing mixture that the polymerisable compound is adsorbed on the surface of the reactive particles, thereby coating the particles and avoiding formation of a (bulk) matrix that incorporates the entire reactive particles.

Often liquids are classified into polar and non-polar liquids in order to characterize properties such as solubility and miscibility with other liquids. Polar liquids typically contain molecules with an uneven distribution of electron density. The same classification may be applied to gases. The polarity of a molecule is reflected by its dielectric constant or its dipole moment. Polar molecules are typically further classified into protic and non-protic (or aprotic) molecules. A fluid, e.g. a liquid, that contains to a large extent polar protic molecules may therefore be termed a polar protic fluid. A fluid, e.g. a liquid, that contains to a large extent polar non-protic molecules may be termed a polar non-protic fluid. Protic molecules contain a hydrogen atom which may be an acidic hydrogen when the molecule is dissolved for instance in water or an alcohol. Aprotic molecules do not contain such hydrogen atoms.

Examples of non-polar liquids include, but are not limited to, hexane, heptane, cyclohexane, benzene, toluene, dichloromethane, carbon tetrachloride, carbon disulfide, dioxane, diethyl ether, or diisopropylether. Examples of dipolar aprotic liquids are methyl ethyl ketone, chloroform, tetrahydrofuran, ethylene glycol monobutyl ether, pyridine, methyl isobutyl ketone, acetone, cyclohexanone, ethyl acetate, isobutyl isobutyrate, ethylene glycol diacetate, dimethylformamide, acetonitrile, N,N-dimethyl acetamide, nitromethane, acetonitrile, N-methylpyrrolidone, methanol, ethanol, propanol, isopropanol, butanol, N,N-diisopropylethylamine, and dimethylsulfoxide. Examples of polar protic liquids are water, methanol, isopropanol, tert.-butyl alcohol, formic acid, hydrochloric acid, sulfuric acid, acetic acid, trifluoroacetic acid, dimethylarsinic acid [(CH₃)₂AsO(OH)], acetonitrile, phenol or chlorophenol. Ionic liquids typically have an organic cation and an anion that may be either organic or inorganic. The polarity of ionic liquids (cf. below for examples) is known to be largely determined by the associated anion. While e.g. halides, pseudohalides, BF₄⁻, methyl sulphate, NO₃⁻, or ClO₄⁻ are polar liquids, hexafluorophosphates, AsF₆⁻, bis(perfluoroalkyl)-imides, and [C₄F₆SO₃]⁻ are non-polar liquids.

The mixing of the polymerisable compound with the plurality of nanoparticles may in some embodiments be carried out in a polar organic solvent such as defined above. In one embodiment the polar organic solvent includes a mixture of isopropanol and ethyl acetate, for example in a molar ratio from about 2 : 1 to about 1 : 10, e.g. about 1:1, about 1 :2, about 1 : 3, about 1 : 5 or about 1 : 10. The mixture of the polymerisable compound and the reactive nanoparticles may be applied onto the barrier layer, and the polymerisable compound may be polymerised to form a polymer. Polymerisation is allowed to occur under conditions that allow the nanoparticles to be encapsulated by the polymer formed, i.e. using a low concentration of the polymerisable compound and, for example, additionally subjecting the sealing mixture to sonification. The sealing solution may be web flight coated onto the barrier layer, for example, via a roll-to-roll process. The coating of barrier layer and sealing layer is repeated for a predetermined number of times to obtain a multilayer film with a desired barrier property. For example, a multilayer film comprising 5 paired layers may be obtained by oxide coating and web flight coating to be repeated 5 times to form 5 paired layer.

In some embodiments a surfactant is added to the mixture of the polymerisable compound and the plurality of nanoparticles. Numerous surfactants, which are partly hydrophilic and partly lipophilic, are used in the art, such as for instance alkyl benzene sulfonates, alkyl phenoxy polyethoxy ethanols, alkyl glucosides, secondary and tertiary amines such as diethanolamine, Tween, Triton 100 and triethanolamine, or e.g. fluorosurfactants such as ZONYL® FSO-100 (DuPont). A surfactant may for instance be a hydrocarbon compound, a hydroperfluoro carbon compound or a perfluorocarbon compound. It may for example be substituted by a sulfonic acid, a sulphonamide, a carboxylic acid, a carboxylic acid amide, a phosphate, or a hydroxyl group. Examples of a hydrocarbon based surfactant include, but are not limted to, sodium dodecyl sulfate, cetyl trimethyl-ammonium bromide, an alkylpolyethylene ether, dodecyldimethyl (3-sulfopropyl) ammonium hydroxide (C₁₂N₃SO₃), hexadecyldimethyl (3-sulfopropyl) ammonium hydroxide (C₁₆N₃SO₃), coco (amidopropyl)hydroxyl dimethylsulfobetaine (RCONH(CH₂)₃N⁺(CH₃)₂CH₂CH(OH)CH₂SO₃⁻ with R=C₈-C₁₈), cholic acid, deoxycholic acid, octyl glucoside, dodecyl maltoside, sodium taurocholate, or a polymer surfactant such as e.g. Supelcoat PS2 (Supelco, Bellefonte, PA, USA), methylcellulose, hydroxypropylcellulose, hydroxyethylcellulose, or hydroxypropylmethylcellulose. The surfactant may for instance be a hydrocarbon compound, a hydroperfluoro carbon compound or a perfluorocarbon compound (supra), which is substituted by a moiety selected from the group consisting of a sulfonic acid, a sulphonamide, a carboxylic acid, a carboxylic acid amide, a phosphate, or a hydroxyl group.

Examples of perfluorocarbon-surfactants include, but are not limited to, pentadecafluorooctanoic acid, heptadecafluorononanoic acid, tridecafluoroheptanoic acid, undecafluorohexanoic acid, 1,1,1,2,4,4,5,5,6,6,7,7,8,8,9,9,10,10,11,11,11-heneicosafluoro-3-oxo-2-undecanesulfonic acid, 1,1,2,2,3,3,4,4,5,5,6,6,6-tridecafluoro-1-hexanesulfonic acid, 2,2,3,3,4,4,5,5-octafluoro-5-[(tridecafluorohexyl)oxy]-pentanoic acid, 2,2,3,3-tetrafluoro-3-[(tridecafluorohexyl)oxy]-propanoic acid], N,N'-[phosphinicobis(oxy-2,1-ethanediyl)]bis[1,1,2,2, 3,3,4,4,5,5,6,6,7,7,8,8,8-heptadecafluoro-N-propyl-1-octanesulfonamide, 1,1,2,2,3,3,4,4,5,5,6, 6,7,7,8,8,8-heptadecafluoro-1-octanesulfonic acid, 1,1,2,2,3,3,4,4,5,5,6,6,7,7,8,8,8-heptadecafluoro-1-octanesulfonyl fluoride, 2-[(β-D-galactopyranosyloxy)methyl]-2-[(1 -oxo-2-propenyl)amino]-1 ,3-propanediyl carbamic acid (3,3,4,4,5,5,6,6,7,7,8, 8,8-tridecafluorooctyl)-ester, 6-(3,3,4,4,5,5,6,6,7,7,8,8,8-tridecafluorooctyl hydrogen phosphate)-D-glucose, 3-(3,3,4,4,5,5, 6,6,7,7,8,8,9,9,10,10,10-heptadecafluorodecyl hydrogen phosphate)-D-glucose, 2-(perfluorohexyl)ethyl isocyanate, 2,2,3,3,4,4,5,5,6,6,7,7,8,8,8-pentadecafluoro-N-phenyl-octanamide, 1,1,2,2,3, 3,4,4,5,5,6,6,7,7,8,8,9,9,10,10,11,11,12,12,12-pentacosafluoro-N-(2-hydroxyethyl)-N-propyl-1-dodecanesulfonamide, 2-methyl-,2-[[(heptadecafluorooctyl)sulfonyl]methylamino]-2-propenoic acid ethyl ester, 3-(2,2,3,3,4,4, 5,5,6,6,7,7,8,8,8-pentadecafluoro-1-oxooctyl)-benzenesulfonic acid, 3-(heptadecafluorooctyl)-benzenesulfonic acid, 4-[(2,2,3,3,4,4,5,5,6,6,7,7,8,8,8-pentadecafluoro-1-oxooctyl)amino]-benzenesulfonic acid, 3-[(o-perfluorooctanoyl)phenoxy]propanesulfonic acid, N-ethyl-1,1,2,2,2-pentafluoro-N-(26-hydroxy-3,6,9,12,15,18,21,24-octaoxahexacos-1-yl)-ethanesulfonamide, 3-[ethyl[(heptadecafluorooctyl)sulfonyl]amino]-1-propanesulfonic acid, 1,2,2,3,3, 4,5,5,6,6-decafluoro-4-(pentafluoroethyl)-cyclohexanesulfonic acid, 2-[1 -[difluoro(pentafluoroethoxy)methyl]-1,2,2,2-tetrafluoroethoxy]-1,1,2,2-tetrafluoro-ethanesulfonic acid, N-[3-(dimethyloxidoamino)propyl]-2,2,3,3,4,4-hexafluoro-4-(heptafluoropropoxy)-butanamide, N-ethyl-N-[(heptadecafluorooctyl)sulfonyl]-glycine, or 2,3,3,3-tetrafluoro-2-[1,1,2,3,3,3-hexafluoro-2-[(tridecafluorohexyl)oxy]propoxy]-1-propanol, to name a few.

Examples of perfluorocarbon-surfactants also include polymeric compounds such as α-[2-[bis(heptafluoropropyl)amino]-2-fluoro-1-(trifluoromethyl)-ethenyl]-ω-[[2-[bis(heptafluoropropyl)amino]-2-fluoro-1-(trifluoromethyl)ethenyl]oxy]-poly-(oxy-1,2-ethanediyl), α-[2-[[(nonacosafluorotetradecyl)sulfonyl]propylamino]ethyl]-ω-hydroxy-poly(oxy-1,2-ethanediyl), polyethylene glycol diperfluorodecyl ether, α-[2-[ethyl-[(heptadecafluorooctyl)sulfonyl]amino]ethyl]-ω-hydroxy-poly(oxy-1,2-ethanediyl), α-[2-[ethyl[(pentacosafluorododecyl)sulfonyl]amino]ethyl]-ω-hydroxy-poly(oxy-1,2-ethanediyl), α-[2-[[(heptadecafluorooctyl)sulfonyl]propylamino]ethyl]-α-hydroxy-poly(oxy-1,2-ethanediyl), N-(2,3-dihydroxypropyl)-2,2-difluoro-2-[1,1,2,2-tetrafluoro-2-[(tridecafluorohexyl)oxy]ethoxy]-acetamide, α-(2-carboxyethyl)-ω-[[(tridecafluorohexyl)oxy]methoxy]-poly(oxy-1,2-ethanediyl),α-[2,3,3,3-tetrafluoro-2-[1 ,1,2, 3,3,3-hexafluoro-2-(heptafluoropropoxy)propoxy]-1-oxopropyl]-ω-hydroxy-poly(oxy-1,2-ethanediyl), and 2,3,3,3-tetrafluoro-2-(heptafluoropropoxy)-propionic acid polymer.

In some embodiments a surface modifying compound such as a silane is added to the sealing mixture. Examples of suitable silanes include acetoxy, alkyl, amino, amino/alkyl, aryl, diamino, epoxy, fluroalkyl, glycol, mercapto, methacryl, silicic acid ester, silyl, ureido, yinyl, and vinyl/alkyl silanes.

Illustrative examples of such silanes include, but are not limited to, di-tert-butoxydiacet-oxysilane, hexadecyltrimeth-oxysilane, alkylsiloxane, Bis(3-triethoxysilylpropyl) amine, 3-aminopropyl-methyldiethoxysilane, triamino-functional propyltrimethoxysilane, phenyltrimethoxysilane, phenyltriethoxysilane, 2-aminoethyl-3-amino-propylmethyl, dimethoxysilane, 2-aminoethyl-3-amino-propyl, trimethoxysilane, proprietary aminosilane composition, 3-glycidyloxy, propyltriethoxysilane, tridecafluoroocty-ltriethoxysilane, polyether-functional trimethoxysilane, 3-mercaptopropyltri-methoxysilane, 3-methacryloxypropyl-trimethoxysilane, ethyl polysilicate, tetra-n-propyl orthosilicate, hexamethyl-disilazane, vinyltrichlorosilane, vinyltrimethoxysilane, vinyl-functional oligosiloxane, 3-methacryloxypropyltrimethoxysilane and combinations thereof.

In some embodiments forming the sealing layer is carried out under an inert atmosphere, which may for example include or consist of nitrogen, argon, neon, helium, and/or sulfur hexafluoride (SF₆).

Forming the one or more barrier layer(s) may be achieved by any suitable deposition method such as spin coating, flame hydrolysis deposition (FHD), slot die coating, curtain gravure coating, knife coating, dip coating, plasma polymerisation or a chemical vapour deposition (CVD) method. Examples of CVD methods include, but are not limited to plasma enhanced chemical vapor deposition (PECVD) or inductive coupled plasma enhanced chemical vapor deposition (ICP-CVD).

In one embodiment the barrier layer is deposited onto a further layer such as a sealing layer or onto a substrate using sputtering techniques known in the art. Sputtering is a physical process of depositing a thin film by controllably transferring atoms from a source to a substrate, which is known in the art. The substrate is placed in a vacuum chamber (reaction chamber) with the source material, named a target, and an inert working gas (such as argon) is introduced at low pressure. A gas plasma is struck in radio frequency (RF) or direct current (DC) glow (ejection of secondary electrons) discharged in the inter gas, which causes the gas to become ionized. The ions formed during this process are accelerated towards the surface of the target, causing atoms of the source material to break off from the target in vapour form and condense on the substrate. Besides RF and DC sputtering, magnetron sputtering is known as third sputtering technique. For magnetron sputtering, DC, pulsed DC, AC and RF power supplies can be used, depending upon target material, if reactive sputtering is desired and other factors. Plasma confinement on the target surface is achieved by locating a permanent magnet structure behind the target surface. The resulting magnetic field forms a closed-loop annular path acting as an electron trap that reshapes the trajectories of the secondary electrons ejected from target into a cycloidal path, greatly increasing the probability of ionization of the sputtering gas within the confinement zone. Positively charged argon ions from this plasma are accelerated toward the negatively biased target (cathode), resulting in material being sputtered from the target surface.

Magnetron sputtering differentiates between balanced and unbalanced magnetron sputtering. An "unbalanced" magnetron is simply a design where the magnetic flux from one pole of the magnets located behind the target is greatly unequal to the other while in a "balanced" magnetron the magnetic flux between the poles of the magnet are equal. Compared to balanced magnetron sputtering, unbalanced magnetron sputtering increases the substrate ion current and thus the density of the substrate coating. In one embodiment a sputtering technique such as RF sputtering, DC sputtering or magnetron sputtering is used to deposit the barrier layer onto the substrate layer. The magnetron sputtering can include balanced or unbalanced magnetron sputtering. In one embodiment, the barrier layer is a sputtered barrier layer.

The barrier stack may be applied onto a substrate, such as a polycarbonate or a PET substrate. In some embodiments a barrier layer may be formed with the aid of a respective substrate. The substrate may be plasma treated and coated with alumina barrier material via magnetron sputtering, thereby forming a barrier layer.

In some embodiments a further material such as ITO may be deposited, e.g. magnetron sputtered, over the multilayer film to form an ITO coating after the multilayer film has been formed. If the encapsulation barrier stack is to be used in Passive Matrix displays, only ITO lines are required instead of a complete coat of IOT. A protective liner is subsequently formed on the ITO coating. Any suitable material may be used, depending on the intended purpose, e.g. scratch resistant films or glare reduction films, such as MgF/LiF films. After forming the protective film, the encapsulation barrier stack is packed in aluminium foil packaging or slit into predetermined dimensions for assembly with other components.

As one of ordinary skill in the art will readily appreciate from the disclosure of the present invention, other compositions of matter, means, uses, methods, or steps, presently existing or later to be developed that perform substantially the same function or achieve substantially the same result as the corresponding exemplary embodiments described herein may likewise be utilized according to the present invention.

### EXEMPLARY EMBODIMENTS

Typical embodiments of a multi-layer barrier stack design of the present invention include a barrier oxide film deposited onto planarized or non-planarized plastic substrate (stretchable or non-stretchable). Functionalized single or multi-layer nanomaterials are deposited on to barrier oxide films. For example, functionalized nano-particles consist of polymer-encapsulated nano-particles and/or functionalized nanoparticle with organic species may be deposited on to a barrier oxide film as a functionalized nanoparticle layer. The functionalized nanoparticles can penetrate into the pores of the barrier oxide film and enhance the barrier properties. The combination of mutually chemically interconnected organic and inorganic nanoparticles results in coatings with very low permeability of gases. If polymer is encapsulated on to the nanoparticle, the ratio of polymer and nanoparticles by weight are preferably 1:4 or less, 1:5 or less, or 1:6 or less.

The functionalized nanoparticle layer (Nano-layer) can be a multi-nanolayer. These functionalized multi-nanolayers can act as a barrier layers and can also act as a UV blocking layer, anti-reflection layer, to enhance the mechanical properties, which includes adhesion, stretchability, weatherablity and optical properties.

For example, the first functionalized nanoparticle layer can be a defect sealing layer and anti-reflection layer and the second layer can be a UV blocking layer and third layer may be a light extraction layer. Therefore, in one barrier stack, the multi-functional properties can be obtained.

In one embodiment, the defect-sealing layer(s) consist of polymer encapsulated titanium nanoparticles, zinc nanoparticles, silica or hollow silica particles. These (polymer encapsulated) particles can be used to enhance the barrier properties of the stack, to block the UV light and have anti-reflection properties in the visible region.

### Functionalization Nanoparticles Layer or Multi-Nano layers

### Substrate Materials

Polymers that may be used in the base substrate in the present invention include both organic and inorganic polymers. Examples of organic polymers which are suitable for forming the base substrate include both high and low permeability polymers such as cellophane, poly(1-trimethylsilyl-1-propyne, poly(4-methyl-2-pentyne), polyimide, polycarbonate, polyethylene, polyethersulfone, epoxy resins, polyethylene terephthalate (PET), polystyrene, polyurethane, polyacrylate, and polydimethylphenylene oxide. Microporous and macroporous polymers such as styrene-divinylbenzene copolymers, polyvinylidene fluoride (PVDF), nylon, nitrocellulose, cellulose or acetate may also be used. Examples of inorganic polymers which are suitable in the present invention include silica (glass), nano-clays, silicones, polydimethylsiloxanes, biscyclopentadienyl iron, polyphosphazenes and derivatives thereof. The base substrate may also include or consist of a mixture or a combination of organic and/or inorganic polymers. These polymers can be transparent, semi-transparent or completely opaque.

### Surface Preparation

The barrier stacks or glass substrates are rinsed with isopropyl alcohol (IPA) and blow-dried with nitrogen. These processes help to remove macro scale adsorbed particles on the surface. Acetone and methanol cleaning or rinsing is not recommended. After nitrogen blow-dry, the substrates are placed in the vacuum oven, with the pressure of 10-1 mbar, for degassing absorbed moisture or oxygen. The vacuum oven is equipped with fore line traps to prevent hydrocarbon oil back migrating from vacuum pump to the vacuum oven. Immediately after the degassing process, the barrier stacks are transferred to the plasma treatment chamber (e.g. ULVAC SOLCIET Cluster Tool). RF argon plasma is used to bombard the surface of the barrier film with low energy ions in order to remove surface contaminants. The base pressure in the chamber was maintained below 4 x 10-6 mbar. The argon flow rate is 70sccm. The RF power is set at 200 W and an optimal treatment time usually 5 to 8 minutes is used depending on the surface condition.

### Inorganic barrier oxide films fabrication

The sputtering technique, EB evaporation and Plasma Enhanced Physical Vapor deposition methods were used to deposit the metal oxide barrier layer. The unbalanced magnetron sputter system is used to develop high-density oxide barrier films. In this sputtering technique, a metal layer of typically a few mono-layers will be deposited from an unbalanced magnetron and then oxygen will be introduced to the system to create oxygen plasma, directed towards the substrate to provide argon and oxygen ion bombardment for a high packing-density oxide film. This plasma will also increase the reactivity of the oxygen directed onto the growing film surface and provides for more desirable structures. In order to deposit dense films without introducing excessive intrinsic stresses, a high flux (greater than 2 mA/cm²) of low energy (∼25 eV) oxygen and argon ions to bombard the growing barrier oxide films.

The continuous feedback control unit is used to control the reactive sputtering processes. The light emitted by the sputtering metal in the intense plasma of the magnetron racetrack is one indicator of the metal sputtering rate and the oxygen partial pressure. This indication can be used to control the process and hence achieve an accurate oxide film stoichiometry. By using a continuous feedback control unit from a plasma emission monitor, reproducible films and desirable barrier properties were obtained. Various barrier layers including SiN, Al₂O₃, and Indium tin oxide were prepared by conventional and unbalanced magnetron sputtering techniques and tested the single barrier layer properties.

In addition, barrier oxide films (SiOₓ & Al₂O₃) were produced by EB evaporation and Plasma enhanced physical vapor deposition methods at the speed of 500 meters/min. Coating thickness is 60nm to 70nm.

### Functionalized Nanoparticle Layer

The surface modification is a key aspect in the use of nanosized materials (also referred to as nanomaterials here). It is the surface that makes the nanosized materials significantly more useful than conventional non-nanomaterials. As the size of the material decreases, its surface-to-volume ratio increases. This presents considerable advantage to modify properties of nanomaterials through surface functionalization techniques. The functionalized nanoparticles are inclusive of polymer encapsulation on to the nanoparticle and organic species passivated nanoparticles. The functionalization techniques, which includes non-covalent (physical) bond and covalent bond (chemical) that can be applied to the nanoparticles. There are several methods available. Ultrasonic cavitation can be used to disperse nano-sized particles into solvent.

Covalent functionalization has been widely investigated and has produced an array of modified nanomaterial bearing small molecules, polymers and inorganic/organic species. Since nanomaterials, although quite small, are much larger than molecules, organic molecules can be used to modify the surfaces of these small particles. In addition to controlling the shape and size of the nanoparticles, controlling the surface of nanomaterial with organic chemistry has played a key role in the barrier stack design.

Surfactants, polymeric surfactants or polymers are employed to passivate or encapsulate the surface of the nanoparticles during or after the synthesis to avoid agglomeration. Generally electrostatic repulsion or steric repulsion can be used to disperse nanoparticles and keep them in a stable colloidal state. Also, surfactants or polymers can be chemically anchored or physically adsorbed on nanomaterials to form a layer stabilization and specific functionalization.

In one embodiment, the methodology for the preparation of polymer encapsulated nanoparticles is explained as below:

The commercially available surface functionalized nanoparticles can be selected according to the desired application. Illustrative examples of surface functionalized nanoparticles include, but are not limited, to 1-Mercapto-(triethylene glycol) methyl ether functionalized Zinc nanoparticles ethanol, colloidal dispersion w/ dispersant, Aluminum oxide, NanoDur™ X1130PMA, 50% in 1,2-propanediol monomethyl ether acetate, colloidal dispersion, Zinc oxide, NanoArc® ZN-2225, 40% in 1,2-propanediol monomethyl ether acetate, colloidal dispersion with dispersant, Zinc oxide, NanoTek® Z1102PMA, 50% in 1,2-propanediol monomethyl ether acetate, colloidal dispersion with dispersant. Examples of silane compounds are inclusive of but limited to alkali, amino, epoxy, methacryl silanes.

A polymer coating can be established on the nanoparticle core via covalent bonding or physical bonding, for example, by means of in situ polymerized monomers or pre-polymers in a discontinuous phase of an inverse mixture. A so obtained polymer-encapsulated nanoparticle may have a size ranging from about 20 nm to about 1000 nm.

In one embodiment, the above surface functionalized aluminium oxide (NanoDur) nanoparticles (20ml) are mixed in the Ethyl acetate (10ml), 3-Methacryloxypropyltrimethoxysilane (10ml) and surfactant (0.5% by weight). THINKY ARE-250 Mixer can undertake the mixing of the above mentioned solution. Sonication time is 2 hours at 28 °C. After that, the monomer can be added by 4% to 6% (2 to 3 ml) by weight of the total solution. The sonication can be undertaken typically 2 hours to 12 hours. The monomer is diluted in the solvent and adsorbed and chemically anchored on the nanoparticles during the Sonication process.

The coating process can be undertaken by spin coating, inkjet printing, slot die coating, gravure printing or any wet coating processes. Then the monomer is cured under UV or heat curing or EB curing processes.

The functionalized nano-particles can penetrate effectively in to pores or the defects of barrier oxide layer and plug the defects. And also, improves the bond strength between barrier oxide layer and functionalized nano-particle layer. The high packing density of the nanoparticle coating can be obtained by the suitable functionalization techniques (coating thickness in the range of 50nm to few hundred nanometers) on to barrier oxide films. The functionalized nano-particles thickness may be determined based on barrier oxide film coating thickness.

In a preferred embodiment, the majority of the polymer coated nano-particles of metal or metal oxide particles and organic species passivated nanoparticles, which include metal and metal oxide, are rod like with a diameter of 10 to 50 nm and length up to 200nm. The diameter and size of the particles are chosen in such a way that they do not influence the transparency of the eventual coatings. The packing density of the nano-particle is determined by the shape and size distribution of the nano-particles. Therefore, it may be advantageous to use nano particles of different shapes and sizes to precisely control the surface nano-structure for the effective sealing of defects of barrier oxide layer.

Polymer encapsulated Carbon nanotubes (CNTs)/carbon particles can be also used to seal the defects of the pinholes. Typically it is advantageous to employ the maximum amount of absorbent particles in order to increase the ability of the sealing layer to seal the barrier oxide films defects and also absorb and retain water and oxygen molecules. The characteristic wavelength is defined as the wavelength at which the peak intensity of OLED or any other displays output light spectrum occurs. When the encapsulation layer designed for Transparent OLED or see-through displays, the size of the particles may be typically less than ½ and preferably less than 1/5 of the characteristic wavelength. Typically these ratios correspond to particle sizes of less than 200nm and preferably less than 100nm. In some barrier designs, larger particles may be desirable, for example where it is required to have scattering of the emitted light.

### Calcium degradation test method

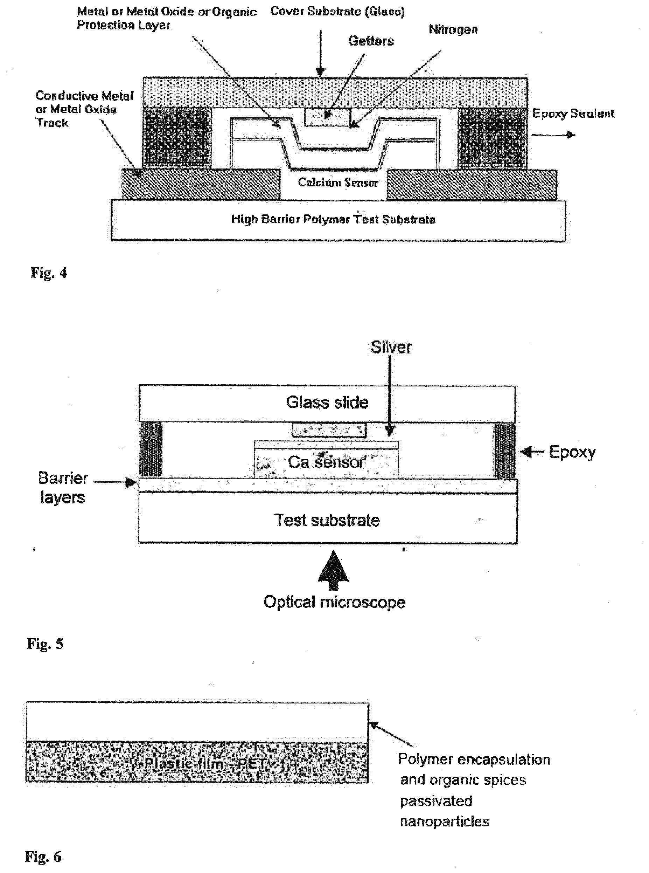

After the plasma treatment process, the barrier stacks are transferred to the vacuum evaporation chamber (thermal evaporation) under vacuum where the two metal tracks that are used as electrodes has dimension 2 cm by 2 cm. The sensing element is fabricated in between the two electrodes and designed with 1 cm long, 2 cm wide and 150 nm thick. The measured resistivity of the sensor element is 0.37Ω-cm. After the deposition process, a load lock system is used to transfer the sample to a glove box under dry nitrogen at atmospheric pressure. After the calcium deposition, a 100 nm silver protection layer were deposited for the qualitative analysis (test cell type A), cf. Fig. 4.

To accelerate the permeation a silver protection layer was deposited for the qualitative analysis (test cell type A). In the case of the quantitative resistance measurement method (test cell type B), cf. Fig. 5, 300 nm silver was used for the conductive track, 150 nm calcium was used as the sensor and 150 nm lithium fluoride was used as a protection layer. After the deposition processes, a UV curable epoxy was applied on the rim of the substrate and then the whole substrate was sealed with a 35mm x 35mm glass slide. The getter material was attached to the 35mm x 35mm cover glass slide in order to absorb any water vapour due to out gassing or permeation through the epoxy sealing. A load lock system was used for the entire process and the test cells were encapsulated in the glove box under dry nitrogen at atmospheric pressure. For the testing, the samples were placed into a humidity chamber at constant temperature and humidity of 80°C & 90% RH respectively. These were viewed optically at regular intervals for a qualitative degradation test and analysis of the defects, and measured electrically for the quantitative analysis of the Calcium degradation.

The Calcium test cell's conductive track terminals are connected to a constant current source (Keithey source meter), which is interfaced with a computer. Resistance of the calcium sensor / silver track is monitored every second and plotted automatically by the computer using lab view software. A Dynamic Signal Analyzer with a FFT analysis is proposed to take the noise spectrum measurement automatically at periodic intervals of one second.

### Experimental Details & Results

### Polymer encapsulated nanoparticles layer (cf. Fig. 6) - Surface topography

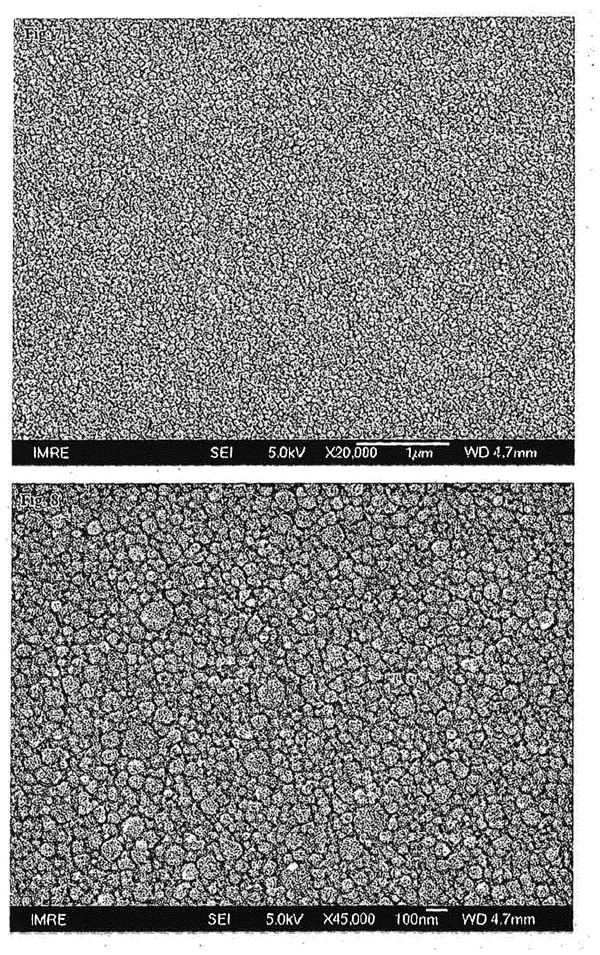

In one example, a solvent mixture of IPA:Ethyleactate in the ratio 5:15 ml is mixed, and 3-Methacryloxypropyltrimethoxysilane 10 ml added. The surfactant Dow corning FZ 2110 is further added to 0.5% by total weight of the solution and mixed. The UV curable acrylate monomer (Addision Clear Wave) - 3 ml is then added in the above mixture. The mixture is kept in sonication for 2 hours. The surface functionalized nanoparticle "Aluminum oxide, NanoDur™ X1130PMA, 50% in 1,2-propanediol monomethyl ether acetate"- 20 ml added to the solvent/monomer mixture and sonicated for few hours. The above mixture was then spin coated and cured. The formulation was undertaken under inert gas environment. The set of experiments were carried out with different mixture of nanoparticles and spin coated onto the plain polymer substrate, barrier coated plastic substrates and aluminum oxide anodisc®. Fig. 7 and Fig. 8 show the surface morphology of the coated polymer encapsulated nanoparticles.

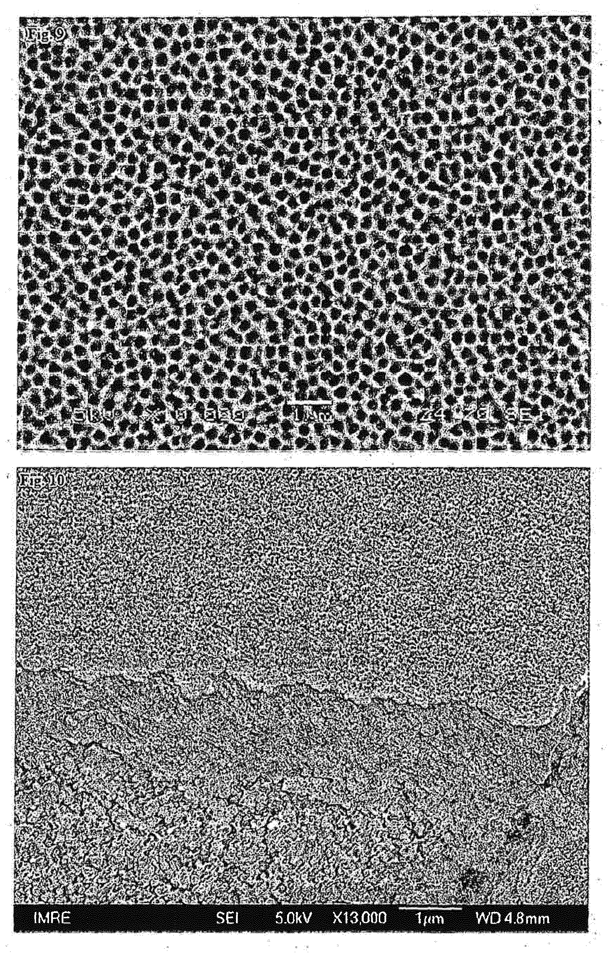

The polymer encapsulated nanoparticle were dispersed on 47 micron thick aluminum oxide anodisc®, which has several pin holes with a diameter of 200nm, and SEM pictures were taken as shown in Fig. 9, 10, 11, and Fig. 13C and D. The anodisc® is rim sealed on to the plastic substrate.

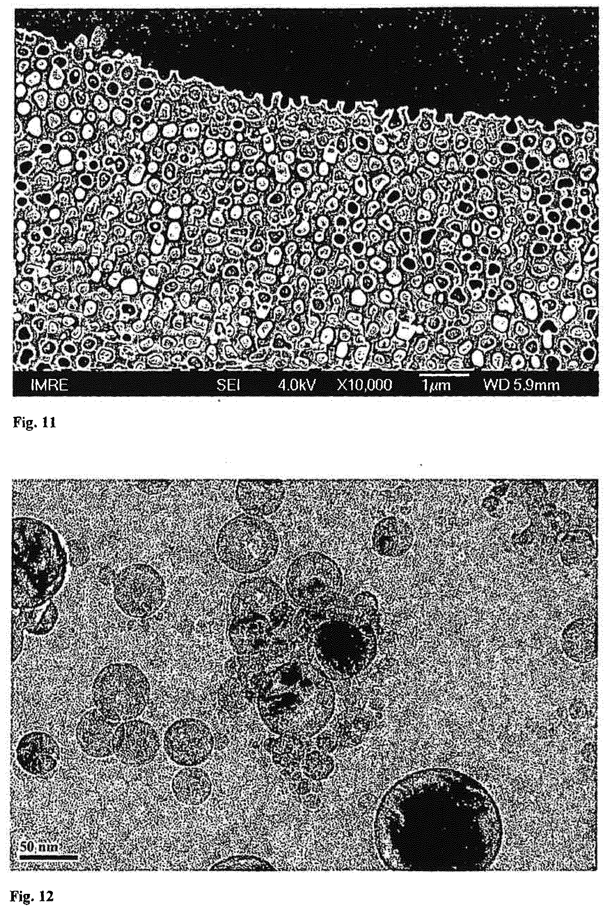

**Figure 12** shows a TEM image illustrating that the nanoparticles are distributed in the polymer layer/film (50nm scale). It is just shown as comparative analysis purpose in order to discriminate the encapsulated nanoparticles vs. nanoparticle distributed in polymer matrix.

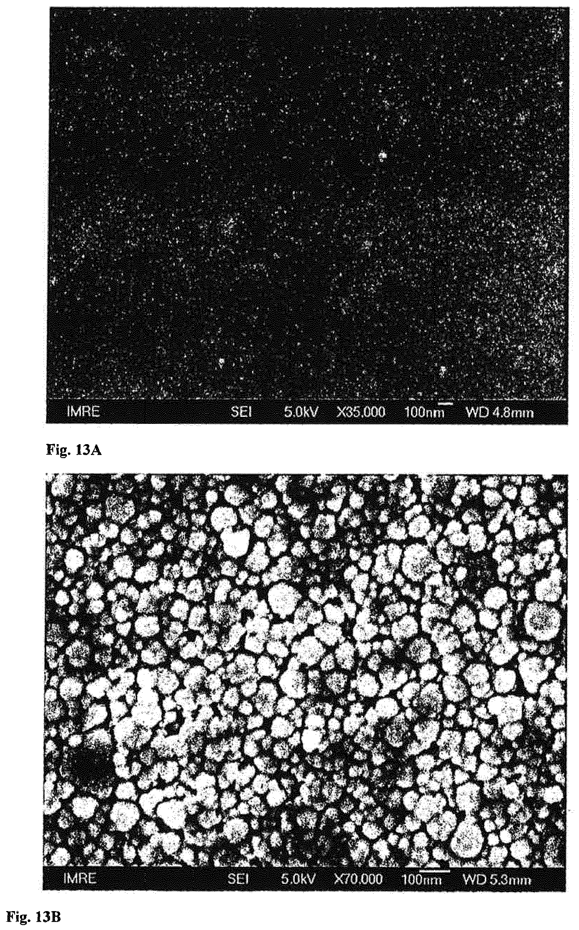

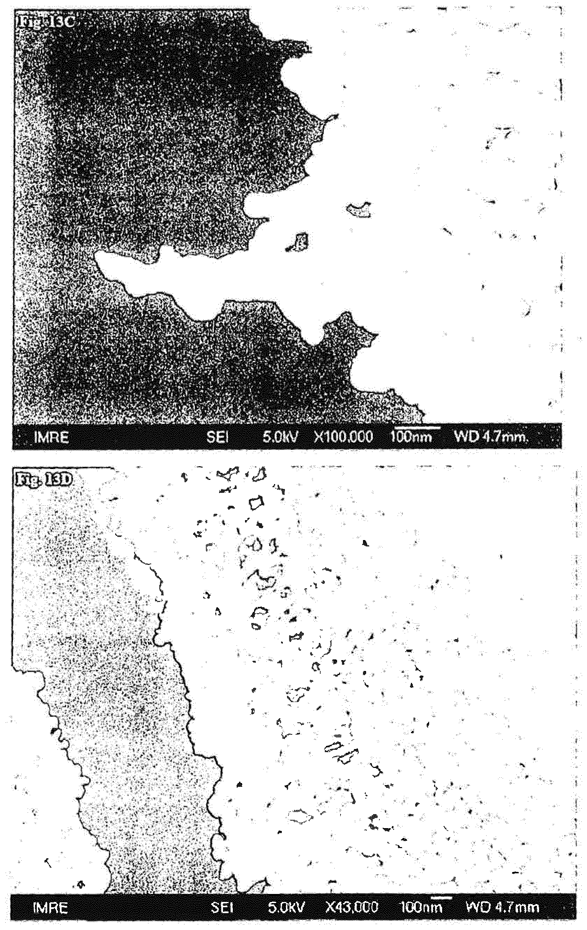

**Figure 13A** shows a SEM image of the distribution of aluminum oxide nanoparticles in a polymer matrix as known in the art at 35.000 x magnification. **Figure 13B** shows a SEM image of prior art aluminium oxide nanoparticles before encapsulation at 70.000 x magnification. **Figure 13C** shows a SEM image of the polymer encapsulated nanoparticles of the invention at 100.000 x magnification and **Figure 13D** shows a SEM image of a layer of polymer encapsulated nanoparticles of the invention.

### Embodiment 1

1. Plastic substrate - PET
2. Polymer encapsulated nanoparticle coating
3. SiN layer-CVD method
4. polymer encapsulated nanoparticle coating
5. SiN layer-CVD method

Nano Solution Preparation: The solvent IPA:Ethyleactate 5:15 ml ratio is mixed, and 3-Methacryloxypropyltrimethoxysilane (10ml) added and then surfactant Dow corning FZ 2110 is further added by 0.5% by total weight of the solution and mixed. The UV curable acrylate monomer (Addision Clear Wave) - (3ml) is then added to the above mixture. The mixture is kept in sonication for 2 hours. The surface functionalized nanoparticle "Aluminum oxide, NanoDur™ X1130PMA, 50% in 1,2-propanediol monomethyl ether acetate"- 20ml is added to the solvent/monomer mixture and sonicated for a few hours. The above mixture was then spin coated and cured. The formulation was undertaken under inert gas environment. The set of experiments were carried out with different mixture of nanoparticles and spin coated onto the plain polymer substrate, barrier coated plastic substrates and aluminum oxide anodisk®. The entire deposition /coating process was carried out by a batch process.

### Embodiment 2

1. Plastic substrate - PET
2. SiOx layer - high speed manufacturing process
3. polymer encapsulated nanoparticle coating
4. SiOx layer - high speed manufacturing process

Nano Solution Preparation: The solvent IPA:Ethyleactate (5:15 ml) ratio is mixed, and 3-Methacryloxypropyltrimethoxysilane (10ml) is added and then surfactant Dow corning FZ 2110 is further added by 0.5% by total weight of the solution and mixed. The UV curable acrylate monomer (Addision Clear Wave) - (3ml) is then added to the above mixture. The mixture kept is in sonication for 2 hours. The surface functionalized nanoparticle "Aluminum oxide, NanoDur™ X1130PMA, 50% in 1,2-propanediol monomethyl ether acetate"- 20ml added to the solvent/monomer mixture and sonicated for few hours. The above mixture was then spin coated and cured. The formulation was undertaken under inert gas environment. The set of experiments were carried out with different mixture of nanoparticles and spin coated onto the plain polymer substrate, barrier coated plastic substrates and aluminum oxide anodisk. Barium titanium ethylhexano-isopropoxide in isopropanol is used to produce 5% BaTiO₃ and to this mixture is added 3-Methacryloxypropyltrimethoxysilane and surfactant Dow corning FZ 2110 and sonicated for 2 hours. A Thinky ARE 250 mixer (available from INTERTRONICS, Oxfordshire, United Kingdom) is then used to mixe the above Al₂O₃ mixture and BaTiO₃ mixtures before the coating process. The entire deposition/coating process was carried out by a batch process. The SiOx layers were both formed by plasma assisted electron beam evaporation process.

### Embodiment 3

1. Plastic substrate - PET
2. Polymer encapsulated nanoparticle layer
3. SiOx layer - high speed manufacturing process
4. Polymer encapsulated nanoparticle coating layer 1 (Defects sealing)
5. Polymer encapsulated nanoparticle coating layer 2 (anti-reflectance)
6. SiOx layer - high speed manufacturing process

Nano Solution Preparation: The solvent IPA:Ethyleactate (5:15 ml ratio) is mixed, and 3-methacryloxypropyltrimethoxysilane (10ml) added and surfactant Dow corning FZ 2110 is further added by 0.5% by total weight of the solution and mixed. The UV curable acrylate monomer (Addision Clear Wave) - (3ml) is then added to the above mixture. The mixture is kept in sonication for 2 hours. The surface functionalized nanoparticle "Aluminum oxide, NanoDur™ X1130PMA, 50% in 1,2-propanediol monomethyl ether acetate"- 20ml is added to the solvent/monomer mixture and sonicated for few hours. The above mixture was then spin coated and cured. The formulation was undertaken under inert gas environment. The set of experiments were carried out also with a different mixture of nanoparticles and spin coated onto the plain polymer substrate, barrier coated plastic substrates and aluminum oxide anodisk®. For this purpose barium titanium ethylhexanol-isopropoxide in isopropanol was used to produce 5% BaTiO₃ and to this mixture 3-methacryloxypropyltrimethoxysilane and surfactant Dow corning FZ 2110 is further added and sonicated for 2 hours. A Thinky ARE 250 mixer (see above) is then used to mix the above Al₂O₃ mixture and BaTiO₃ mixtures before the coating process.

In the layer 2, the Zinc oxide, NanoTek® Z1102PMA, 50% in 1,2-propanediol monomethyl ether acetate, colloidal dispersion with dispersant, and 3-Methacryloxypropyltrimethoxysilane 10ml is added and surfactant Dow corning FZ 2110 is further added by 0.5% by total weight of the solution and mixed. The UV curable acrylate monomer (Addision Clear Wave) - (3ml) is then added to the above mixture. The mixture is kept in sonication for 2 hours. The surface modified Zinc oxide, NanoTek® in 1,2-propanediol monomethyl ether acetate, colloidal dispersion with dispersant - 20ml added to the solvent/monomer mixture and sonicated for few hours. The above mixture was then spin coated and cured. The formulation was undertaken under inert gas environment. Titanium in isopropanol to produce 5% of titanium oxide and 3-Methacryloxypropyltrimethoxysilane and then doped surfactant Dow corning FZ 2110 is added. This mixture was sonicated for 2 hours. A Thinky ARE 250 mixer is used to mix the above zinc oxide mixture and BaTiO₃ mixtures before the coating process. The entire deposition/coating process was carried out by a batch process. The SiOx layers were both formed by plasma assisted electron beam evaporation process.

### Embodiment 4

1. Plastic substrate - PET
2. Polymer encapsulated nanoparticle layer
3. SiOx layer - high speed manufacturing process
4. Polymer encapsulated nanoparticle coating layer 1 (defects sealing)
5. Polymer encapsulated nanoparticle coating layer 2 (anti-reflectance)
6. SiOx layer - high speed manufacturing process

Nano Solution Preparation: The solvent IPA:Ethyleactate (5:15 ml) ratio is mixed, and 3-Methacryloxypropyltrimethoxysilane (10ml) and surfactant Dow corning FZ 2110 is further added by 0.5% by total weight of the solution and mixed. The UV curable acrylate monomer (Addision Clear Wave) - (3ml) is then added to the above mixture. The mixture is kept in sonication for 2 hours. The surface functionalized nanoparticle "Aluminum oxide, NanoDur™ X1130PMA, 50% in 1,2-propanediol monomethyl ether acetate"- 20ml is added to the solvent/monomer mixture and sonicated for few hours. The above mixture was then spin coated and cured. The formulation was undertaken under inert gas environment. The set of experiments were carried out with different mixture of nanoparticles and spin coated onto the plain polymer substrate, barrier coated plastic substrates and aluminum oxide anodisk®. Barium titanium ethylhexano-isopropoxide in isopropanol is used to produce 5% BaTiO₃ and 3-methacryloxypropyltrimethoxysilane added and surfactant Dow corning FZ 2110 is further added and sonicated for 2 hours. A Thinky ARE 250 mixer is then used to mix the above Al₂O₃ mixture and BaTiO₃ mixture before the coating process.

In the layer 2, the Zinc oxide, NanoTek® Z1102PMA, 50% in 1,2-propanediol monomethyl ether acetate, colloidal dispersion with dispersant and 3-methacryloxypropyltrimethoxysilane (10ml) is added and surfactant Dow corning FZ 2110 is further added by 0.5% by total weight of the solution and mixed. The UV curable acrylate monomer (Addision Clear Wave) - 3ml is then added to the above mixture. The mixture is kept in sonication for 2 hours. The surface modified Zinc oxide, NanoTek® in 1,2-propanediol monomethyl ether acetate, colloidal dispersion with dispersant - (20ml) is added to the solvent/monomer mixture and sonicated for few hours. The formulation was undertaken under inert gas environment. Titanium in isopropanol to produce 5% of titanium oxide and 3-Methacryloxypropyltrimethoxysilane added and then doped surfactant Dow corning FZ 2110. This mixture was sonicated for 2 hours. A Thinky ARE 250 mixer was used to mix the above zinc oxide and titanium oxide mixture and BaTiO₃ mixture before the coating process. The entire deposition/coating process was carried out by a batch process. The SiOx layers were both formed by plasma assisted electron beam evaporation process.

### Embodiment 5

1. Plastic substrate - PET
2. Al₂O₃ layer - sputtering manufacturing process
3. Polymer encapsulated nanoparticle coating layer 1 (sealing layer)
4. Nanoparticle distributed in polymer matrix
5. Al₂O₃ layer - sputtering manufacturing process

Nano Solution Preparation: The solvent IPA:Ethyleactate (5:15 ml) ratio is mixed, and 3-Methacryloxypropyltrimethoxysilane (10ml) and surfactant Dow corning FZ 2110 is further added by 0.5% by total weight of the solution and mixed. The UV curable acrylate monomer (Addision Clear Wave) - (1.5 ml) is then added to the above mixture. The mixture is kept in sonication for 2 hours. The surface functionalized nanoparticle "Aluminum oxide, BYK 3610, 30% in 1,2-propanediol monomethyl ether acetate"- 40ml is added to the solvent/monomer mixture and sonicated for few hours. The above mixture was then coated in a roll to roll slot die coating process and cured. The formulation was undertaken under inert gas environment. The set of experiments were carried out with different mixture of nanoparticles and coated onto a barrier coated plastic substrates, with Al2O3 being the barrier layer.

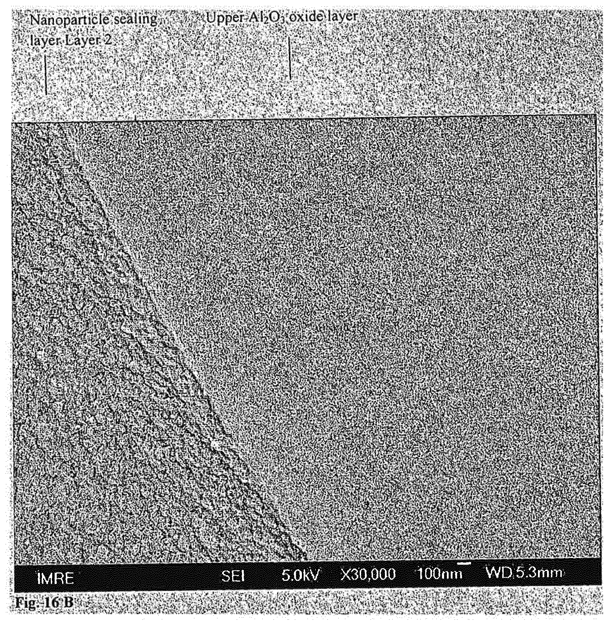

In the layer 2, aluminum oxide, BYK 3610 30% in 1,2-propanediol monomethyl ether acetate (28 ml), colloidal dispersion with dispersant and 3-methacryloxypropyltrimethoxysilane (both 10ml) is added and surfactant Dow corning FZ 2110 is further added by 0.5% by total weight of the solution and mixed. The UV curable acrylate monomer (Addision Clear Wave) - 40 ml is then added to the above mixture. The mixture is kept in sonication for 2 hours. The above mixture was then coated in a roll to roll slot die coating process and UV cured so that the nanoparticles were encapsulated in the polymer matrix. Note in this regard the much higher amount of UV curable monomer (40 ml) used for this layer than the 1.5 ml used for layer 1 in which the nanoparticles are only surface-encapsulated/modified but in which no polymer matrix that embeds the nanoparticles is formed. After that the Al₂O₃ layer is formed by roll to roll sputtering. The resulting barrier stack is shown in **Fig. 16** in which Fig. **16A** shows the layer 1 and the layer 2, however not the layer of the nanoparticles distributed in the polymer matrix nor the upper Al₂O₃ layer. The layer of the nanoparticles distributed in the polymer matrix and the upper Al₂O₃ layer are shown in **Fig. 16B****.**

### Embodiment 6

1. Plastic substrate - PET
2. Al₂O₃ layer - sputtering manufacturing process
3. Polymer encapsulated nanoparticle coating layer 1 (defects sealing)
4. Al₂O₃ layer - sputtering manufacturing process

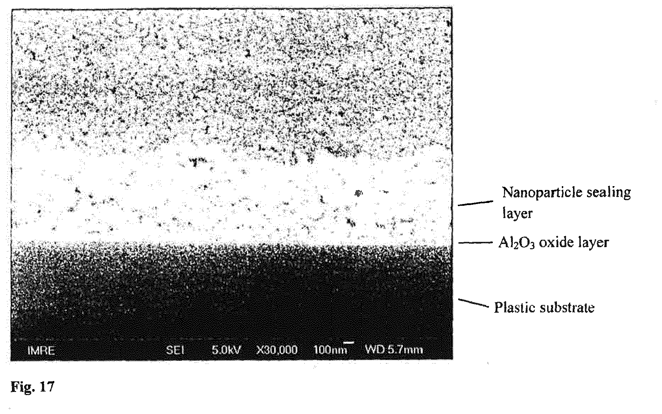

Nano Solution Preparation: The solvent IPA:Ethyleactate (5:15 ml) ratio is mixed, and 3-Methacryloxypropyltrimethoxysilane (10ml) and surfactant Dow corning FZ 2110 is further added by 0.5% by total weight of the solution and mixed. The UV curable acrylate monomer (Addision Clear Wave) - (1.5 ml) is then added to the above mixture. The mixture is kept in sonication for 2 hours. The surface functionalized nanoparticle "Aluminum oxide, BYK 3610, 30% in 1,2-propanediol monomethyl ether acetate"- 40ml is added to the solvent/monomer mixture and sonicated for few hours. The above mixture was then coated in a roll to roll slot die coating process and cured. The formulation was undertaken under inert gas environment. The set of experiments were carried out with different mixture of nanoparticles and coated onto the plain polymer substrate or an barrier coated plastic substrates, with Al₂O₃ being the barrier layer. After formation of the nanoparticle sealing layer onto the Al₂O₃ oxide, the top Aₗ₂O₃ layer is formed by roll to roll sputtering. An image (cross-section) of the resulting barrier stack is shown in **Fig.17** (the upper aluminum layer is not shown in **Fig. 17**).

| Structure | WVTR at 60°C & 90% RH | Transmittance | UV filter | Reduction of reflectance in UV-visible range |
|---|---|---|---|---|
| Embodiment 1 PET/polymer encapsulated nanolayer/SiN (SiN deposited by CVD process) | no calcium oxidation up to 300 hours 8 x 10⁻⁴g/m^{2.}day | 88% | - | - |
| Embodiment 1 PET/polymer encapsulated nanolayer/SiN/polymer encapsulated nanolayer/SiN | no calcium oxidation up to 1600 hours. 2 x 10⁻⁶g/m^{2.}day | 87% | - | - |
| Embodiment 2 PET/SiOx alone (by high speed manufacturing process) | no calcium oxidation up to 2 hours>2g/m^{2.} day | 88% | - | - |
| Embodiment 2 PET/SiOx/polymer encapsulated nanolayer/SiOx | no calcium oxidation up to 300 hours 6 x 10^{-4g}/ₘ^{2.}day | 88% | - | - |
| Embodiment 3 | no calcium oxidation up 400 hours 3 x 10-4g/m^{2.}day | 88% | 30% at 350nm | |
| Embodiment 4 | no calcium oxidation up to 360 hours 4 x 10-4g/m^{2.}day | 88% | - | 5 to 7% |
| Embodiment 5 | Less than 1 x 10⁻⁴g/m^{2.}day | 85 % | - | - |
| Embodiment 6 | Less than 1 x 10⁻⁴g/m^{2.}day | 85 % | - | - |

### Adhesion Test:

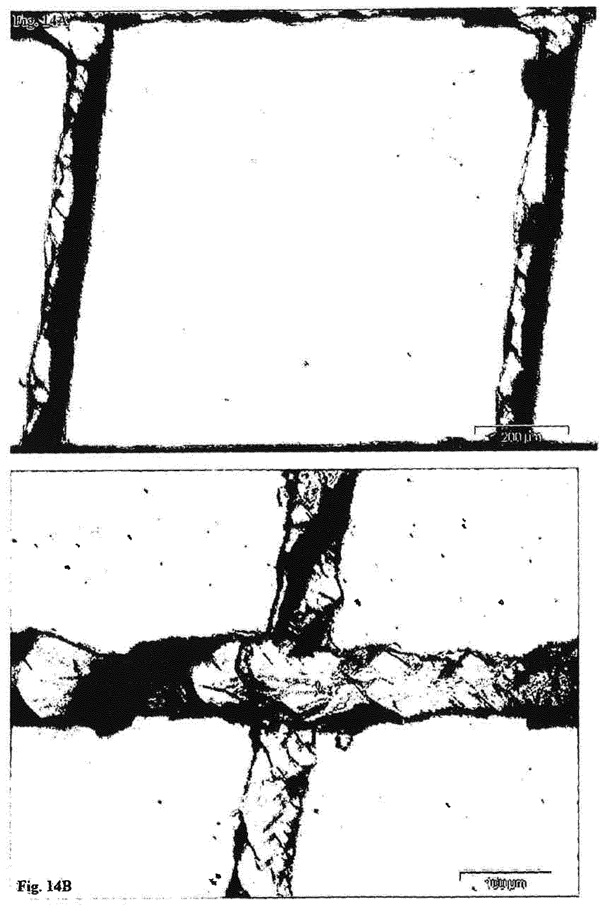

The polymer-encapsulated nanolayer as described in embodiment 1 was deposited on to aluminum oxide coated PET substrate. The adhesion test was performed as per the ASTM STD 3359. The cross-cut tool from BYK was used to make a perpendicular cut on the coatings. The permacel tape was used to peel the coating and the peeled area was inspected using optical microscope. There is no peel-off polymer encapsulated nanolayer from the aluminum oxide coated PET substrate as shown in **Fig. 14A** and **Fig. 14B****.**

The listing or discussion of a previously published document in this specification should not necessarily be taken as an acknowledgement that the document is part of the state of the art or is common general knowledge.

The invention illustratively described herein may suitably be practiced in the absence of any element or elements, limitation or limitations, not specifically disclosed herein. Thus, for example, the terms "comprising", "including," containing", etc. shall be read expansively and without limitation. Additionally, the terms and expressions employed herein have been used as terms of description and not of limitation, and there is no intention in the use of such terms and expressions of excluding any equivalents of the features shown and described or portions thereof, but it is recognized that various modifications are possible within the scope of the invention claimed. Thus, it should be understood that although the present invention has been specifically disclosed by exemplary embodiments and optional features, modification and variation of the inventions embodied therein herein disclosed may be resorted to by those skilled in the art, and that such modifications and variations are considered to be within the scope of this invention.

The invention has been described broadly and generically herein. Each of the narrower species and subgeneric groupings falling within the generic disclosure also form part of the invention. This includes the generic description of the invention with a proviso or negative limitation removing any subject matter from the genus, regardless of whether or not the excised material is specifically recited herein.

Other embodiments are within the following claims. In addition, where features or aspects of the invention are described in terms of Markush groups, those skilled in the art will recognize that the invention is also thereby described in terms of any individual member or subgroup of members of the Markush group.

### The invention is further characterised by the following items:

**1.** An encapsulation barrier stack, capable of encapsulating a moisture and/or oxygen sensitive article and comprising a multilayer film, wherein the multilayer film comprises:
   - one or more barrier layer(s) having low moisture and/or oxygen permeability, and
   - one or more sealing layer(s) arranged to be in contact with a surface of the at least one barrier layer, thereby covering and/ or plugging defects present in the barrier layer,
   wherein the one or more sealing layer(s) comprise(s) a plurality of encapsulated nanoparticles, the nanoparticles being reactive in that they are capable of interacting with moisture and/or oxygen to retard the permeation of moisture and/or oxygen.
**2.** The encapsulation barrier stack of item 1, wherein the one or more sealing layer(s) at least essentially consist(s) of the encapsulated reactive nanoparticles.
**3.** The encapsulation barrier stack of item 1 or item 2, wherein at least a portion of the plurality of encapsulated nanoparticles have an aliphatic, alicyclic, aromatic or arylaliphatic compound immobilized thereon, the aliphatic, alicyclic, aromatic or arylaliphatic compound having a polar group.
**4.** The encapsulation barrier stack of item 3, wherein the polar group is selected from the group of a hydroxyl, a carboxyl, an amido, a thio, a seleno, a telluro group and combinations thereof.
**5.** The encapsulation barrier stack according to any of items 1 to 4, wherein the nanoparticles are encapsulated by a polymeric material (polymer encapsulated nanoparticles), or wherein the encapsulation material comprises an oligomer.
**6.** The encapsulation barrier stack of any of items 1 to 5, wherein the encapsulation material is selected from the group consisting of an organic polymer, inorganic polymer, a water soluble polymer, organic solvent soluble polymer, biological polymer, synthetic polymer and oligomer.
**7.** The encapsulation barrier stack of any of items 5 or 6, wherein a pre-polymer is used for encapsulation.
**8.** The encapsulation barrier stack according to item 7, wherein the pre-polymer is an acrylic oligomer having a molecular weight less than about 1000 Da and a viscosity less than about 300 cPoise.
**9.** The encapsulation barrier stack of any of items 3 to 8, wherein the encapsulation material is an organic material that includes a mercapto group, an epoxy group, an acrylic group, a methacrylate group, an allyl group, a vinyl group, a halogen and an amino group.
**10.** The encapsulation barrier stack of any of items 1 to 9, wherein the encapsulation material is, prior to the encapsulation, cross-linked or cross-linkable, a UV curable group, electron beam curable or heat curable material.
**11.** The encapsulation barrier stack of any of items 1 to 10, wherein the nanoparticles are selected from pigment particles, quantum dots, colloidal particles, and combinations thereof
**12.** The encapsulation barrier stack of any one of items 1 to 11, being adapted to be arranged on a substrate.
**13.** The encapsulation barrier stack of any one of the foregoing items, wherein one of the one or more sealing layers conforms substantially to the shape of the defects present on the surface of one of the one or more barrier layers.
**14.** The encapsulation barrier stack of item 12, wherein the sealing layer is formed by conformal deposition.
**15.** The barrier stack of any one of items 1 to 14, wherein the multilayer film comprises a plurality of sealing layers and barrier layers arranged in an alternating sequence.
**16.** The barrier stack of any one of items 1 to 15, wherein the multilayer film comprises a single sealing layer.
**17.** The barrier stack of any one of the preceding items, wherein the multilayer film comprises a single barrier layer.
**18.** The barrier stack of any one of the preceding items, wherein the nanoparticles are capable of interacting with moisture and/or oxygen through chemical reaction.
**19.** The barrier stack of any one of the preceding items, wherein the nanoparticles comprise a material selected from the group consisting of a metal, a metal oxide and a combination thereof.
**20.** The barrier stack of any one of the preceding items, comprising a plurality of sealing layers, wherein each of the plurality of sealing layers comprises a different material.
**21.** The barrier stack of items 19 or 20, wherein the nanoparticles comprise a metal selected from the group consisting of Al, Ti, Mg, Ba, Ca and alloys thereof.
**22.** The barrier stack of any one of items 19 to 21, wherein the nanoparticles comprise a metal oxide selected from the group consisting of TiO₂, AbO₃, ZrO₂, ZnO, BaO, SrO, CaO, MgO, VO₂, CrO₂, MoO₂, and LiMn₂O₄.
**23.** The barrier stack of any one of items 19 to 22, wherein the nanoparticles comprise a transparent conductive oxide selected from the group consisting of cadmium stannate (Cd₂SnO₄), cadmium indate (CdIn₂O₄), zinc stannate (Zn₂SnO₄ and ZnSnO₃), and zinc indium oxide (Zn₂In₂O₅), barium titanate and barium strontium titanate.
**24.** The barrier stack of any one of items 1 to 23, wherein the nanoparticles are capable of interacting with moisture and/or oxygen through adsorption.
**25.** The barrier stack of item 24, wherein the nanoparticles comprise carbon nanotubes and or graphene nano-sheets or nanoflakes.
**26.** The barrier stack of any one of the preceding items, wherein at least one of the one or more sealing layers further comprises a plurality of inert nanoparticles, the inert nanoparticles being capable of obstructing the permeation of moisture and/or oxygen through the defects present in the barrier layer.
**27.** The barrier stack of item 26, wherein the inert nanoparticles comprise a material selected from the group consisting of gold, copper, silver, platinum, silica, wollastonite, mullite, monmorillonite, silicate glass, fluorosilicate glass, fluoroborosilicate glass, aluminosilicate glass, calcium silicate glass, calcium aluminium silicate glass, calcium aluminium fluorosilicate glass, titanium carbide, zirconium carbide, zirconium nitride, silicon carbide, silicon nitride, a metal sulfide, and a mixture or combination thereof.
**28.** The barrier stack of any one of the preceding items, wherein the nanoparticles comprised in the one or more sealing layers have a size that is smaller than the average diameter of defects present in the one or more barrier layers.
**29.** The barrier stack of any one of the preceding items, wherein the oxygen and/or moisture sensitive article comprises an electroluminescent electronic component or a solar device, and wherein the average size of the nanoparticles is less than one-half the characteristic wavelength of light produced by the electroluminescent electronic component or absorbed by the solar device.
**30.** The barrier stack of any one of items 1 to 29, wherein the barrier layer comprises a material selected from indium tin oxide (ITO), TiAlN, SiO₂, SiC, Si3N₄, TiO₂, HfO₂, Y₂O₃, Ta₂O₅, and Al₂O₃.
**31.** The barrier stack of any one of the preceding items, further comprising a substrate for supporting the multilayer film.
**32.** The barrier stack of item 31, wherein the multilayer film is orientated such that the sealing layer is arranged on the substrate.
**33.** The barrier stack of item 32, wherein the multilayer film is orientated such that the barrier layer is arranged on the substrate.
**34.** The barrier stack of any of Items 30 to 33, wherein the substrate comprises a material selected from polyacetate, polypropylene, polyimide, cellophane, poly(1-trimethylsilyl-1-propyne, poly(4-methyl-2-pentyne), polyimide, polycarbonate, polyethylene, polyethersulfone, epoxy resins, polyethylene terepthalate, polystyrene, polyurethane, polyacrylate, and polydimethylphenylene oxide, styrenedivinylbenzene copolymers, polyvinylidene fluoride (PVDF), nylon, nitrocellulose, cellulose, glass, indium tin oxide, nano-clays, silicones, polydimethylsiloxanes, biscyclopentadienyl iron, and polyphosphazenes.
**35.** The barrier stack of any of items 30 to 34, wherein the substrate is flexible.
**36.** The barrier stack of any of items 30 to 34, wherein the substrate is rigid.
**37.** The barrier stack of any one of items 30 to 36, further comprising a planarising layer, wherein the planarising layer is arranged between the substrate and the multilayer film.
**38.** The barrier stack of any one of items 1 to 37, further comprising a terminal layer for protecting the multilayer film, wherein the terminal layer is facing the ambience.
**39.** The barrier stack of item 38, wherein the terminal layer comprises an acrylic film or wherein the terminal layer is an oxide layer.
**40.** The barrier stack of item 39, wherein the acrylic film has distributed therein LiF and/or MgF₂ particles.
**41.** The barrier stack of any one of the preceding items, wherein the encapsulation barrier stack has a water vapour permeation rate of less than about 10⁻³ g/m²/day, less than about 10⁻⁴ g/m²/day, 10⁻⁵ g/m²/day or less than about 10⁻⁶ g/m²/day.
**42.** The barrier stack of any one of the preceding items, wherein the one or more sealing layers provide moisture and oxygen barrier properties and at least one property selected from the group of, a UV filter property, an antireflection property, a light extraction property and an anti-static property.
**43.** The barrier stack of any one of the preceding items further comprising arranged on the at least one sealing layer a further layer.
**44.** The barrier stack of item 43, wherein the further layer is a polymer layer containing no reactive nanoparticles or a polymer layer in which reactive nanoparticles are distributed in a polymeric matrix.
**45.** An electronic module comprising an electronic device that is sensitive to moisture and/or oxygen, said electronic device being arranged within an encapsulation barrier stack according to any one of items 1 to 44.
**46.** The electronic module of item 45, wherein the electronic device is selected from the group consisting of an Organic Light Emitting Device (OLED), a charged-coupled device (CCD), a Liquid Crystal Display (LCD), a solar cell, a thin-film battery, an Organic Thin Film Transistor (OTFT), an organic Integrated Circuit (IC), an organic sensor, and a micro-electro-mechanical sensor (MEMS).
**47.** The electronic module of item 45 or 46, wherein the barrier stack defines a base substrate for supporting the electronic device.
**48.** The electronic module of item 45 or 46, wherein the encapsulation barrier stack further comprises a covering layer arranged proximally above the electronic device, thereby defining a proximal encapsulation, the electronic device being sandwiched between the covering layer and the encapsulation barrier stack.
**49.** The electronic module of item 48, wherein the shape of the covering layer conforms to the external shape of the electronic device.
**50.** The electronic module of item 45 or 46, wherein the electronic device is arranged on a base substrate, and the encapsulation barrier stack forms an encapsulation layer over the electronic device that seals the electronic device against the base substrate.
**51.** A method of manufacturing an encapsulation barrier stack according to any one of items 1 to 44, the method comprising:
   - providing one or more barrier layer(s), and
   - forming one or more sealing layer(s), wherein forming the one or more sealing layer(s) comprises
      (i) mixing a polymerisable compound or a cross-linkable compound with a plurality of nanoparticles, the nanoparticles being reactive in that they are capable of interacting with moisture and/or oxygen, thereby forming a sealing mixture,
      (ii) applying the sealing mixture onto the barrier layer and polymerising the polymerisable compound or to cross-link the cross-linkable compound to form a polymer under conditions allowing the nanoparticles to be encapsulated by the formed polymer.
**52.** The method of item 51, further comprising adding a surfactant to the sealing mixture.
**53.** The method of item 51 or 52, further comprising adding a surface modifying compound to the sealing mixture.
**54.** The method of item 53, wherein the surface modifying compound is a silane.
**55.** The method of any one of items 51 to 54, wherein providing the one or more barrier layer(s) comprises forming the one or more barrier layer(s).
**56.** The method of any one of items 51 to 55, wherein the conditions and/or the concentration of the polymerisable compound is chosen such that the polymerisable compound is immobilized on the surface of the reactive nanoparticles.
**57.** The method of any one of items 51 to 56 wherein the sealing mixture is applied onto the barrier layer via conformal deposition.
**58.** The method of items 57, wherein the sealing mixture is applied onto the barrier layer by means of spin coating, screen printing, a WebFlight method, slot die, curtain gravure, knife coating, ink jet printing, screen printing, dip coating, plasma polymerisation or a chemical vapour deposition (CVD) method.
**59.** The method of any one of items 52 to 58, wherein after being deposited onto the barrier layer the sealing mixture is exposed to conditions that initiate polymerization of the polymerisable compound or cross-linking the cross-linkable compound.
**60.** The method of item 59, wherein the conditions that initiate polymerization comprise UV radiation or IR radiation, electron beam curing, plasma polymerisation (for curing of the polymerisable compound or crosslinking the cross-linkable compound).
**61.** The method of any of items 51 to 60, wherein the one or more sealing layer(s) formed at least essentially consist(s) of the polymer encapsulated reactive nanoparticles.
**62.** The method of any of items 51 to 61, further comprising carrying out sonification of the sealing mixture prior to polymerisation.
**63.** The method of item 62, wherein sonification is carried out for at least about 30 minutes.
**64.** The method of any one of items 51 to 63, the method further comprising providing a substrate for supporting the barrier stack.
**65.** The method of item 64, wherein the substrate comprises the barrier layer.
**66.** The method of any one of items 51 to 65, wherein the substrate comprises a polymer.
**67.** The method of any one of items 51 to 66, wherein the plurality of nanoparticles is a colloidal dispersion comprising nanoparticles dispersed in an organic solvent.
**68.** The method of any one of items 51 to 67, wherein the mixing of the polymerisable compound with the plurality of nanoparticles is carried out in a polar organic solvent.
**69.** The method of item 68, wherein the polar organic solvent comprises a mixture of isopropanol and ethyl acetate in 1 : 3 molar ratio.
**70.** The method of any one of items 51 to 69, wherein the polymerisable or cross-linkable compound is curable by ultraviolet light, infrared light, electron beam curing, plasma polymerisation and or heat curing.
**71.** The method of item 70, wherein the polymerisable compound is selected from acrylic acid, methyl acrylate, ethyl acrylate and butyl acrylate or wherein the cross-linkable compound is an oligomer or a polymer.
**72.** The method of any one of items 51 to 71 wherein mixing of the polymerisable or cross-linkable compound with the plurality of nanoparticles in step (i) comprises mixing about 20 wt.-% dry form or less of the monomer to 80 wt.-% dry form of the nanoparticles (weight ratio 1:4 or less).
**73.** The method of item 72, wherein the polymerisable or cross-linkable compound is mixed with the nanoparticle at a weight ratio of 1: 5 or less.
**74.** The method of any of items 51 to 73, wherein the sealing mixture obtained in step (i) comprises 10 % (w/v) or less of the polymerizable or cross-linkable compound.
**75.** The method of item 74, wherein the sealing mixture comprises about 5 % (w/v) of the polymerizable or cross-linkable compound.
**76.** Use of polymer encapsulated reactive nanoparticles for preparing a sealing layer of a barrier stack, wherein the nanoparticles are reactive in that they are capable of interacting with moisture and/or oxygen to retard the permeation of moisture and/or oxygen through the defects present in the barrier layer.
**77.** Use of an encapsulation barrier stack for use in food packaging or pharmaceutical packaging or medical packaging.

## Claims

1. An encapsulation barrier stack, capable of encapsulating a moisture and/or oxygen sensitive article and comprising a multilayer film, wherein the multilayer film comprises:
- one or more barrier layer(s), and
- one or more sealing layer(s) arranged to be in contact with a surface of the at least one barrier layer, thereby covering and/or plugging defects present in the barrier layer,
wherein the one or more sealing layer(s) comprise(s) a plurality of encapsulated nanoparticles, the nanoparticles being reactive in that they are capable of interacting with moisture and/or oxygen by way of chemical reaction or through physical or physico-chemical interaction;
wherein the nanoparticles are encapsulated by encapsulation shells comprising a polymeric or oligomeric encapsulation material, and wherein the encapsulation shells partially or entirely cover the surface of the nanoparticles.

2. The encapsulation barrier stack of claim 1, wherein the one or more sealing layer(s) essentially consist(s) of the encapsulated reactive nanoparticles.

3. The encapsulation barrier stack of claim 1 or claim 2, wherein at least a portion of the plurality of encapsulated nanoparticles have an aliphatic, alicyclic, aromatic or arylaliphatic compound immobilized thereon, the aliphatic, alicyclic, aromatic or arylaliphatic compound having a polar group.

4. The encapsulation barrier stack according to any of claims 1 to 3, wherein the encapsulation material is selected from the group consisting of an organic polymer, inorganic polymer, a water soluble polymer, organic solvent soluble polymer, biological polymer, synthetic polymer and oligomer,
preferably wherein a pre-polymer is used for encapsulation.

5. The encapsulation barrier stack of any of claims 1 to 4, wherein the nanoparticles comprise a material selected from the group consisting of a metal, a metal oxide and a combination thereof.

6. The encapsulation barrier stack of claim 5, wherein the nanoparticles comprise:
(a) a metal selected from the group consisting of Al, Ti, Mg, Ba, Ca and alloys thereof; and/or
(b) a metal oxide selected from the group consisting of TiO₂, Al₂O₃, ZrO₂, ZnO, BaO, SrO, CaO, MgO, VO₂, CrO₂, MoO₂, and LiMn₂O₄; and/or
(c) a transparent conductive oxide selected from the group consisting of cadmium stannate (Cd₂SnO₄), cadmium indate (CdIn₂O₄), zinc stannate (Zn₂SnO₄ and ZnSnO₃), and zinc indium oxide (Zn₂In₂O₅), barium titanate and barium strontium titanate.

7. The encapsulation barrier stack of any of claims 1 to 6, wherein the barrier layer comprises a material selected from indium tin oxide (ITO), TiAlN, SiO₂, SiC, Si₃N₄, TiO₂, HfO₂, Y₂O₃, Ta₂O₅, and Al₂O₃.

8. The encapsulation barrier stack of any of claims 1 to 7, further comprising a substrate for supporting the multilayer film.

9. The encapsulation barrier stack of any one of claims 1 to 8, further comprising a terminal layer for protecting the multilayer film, wherein the terminal layer is facing the ambience.

10. A method of manufacturing an encapsulation barrier stack according to any one of claims 1 to 9, the method comprising:
- providing one or more barrier layer(s), and
- forming one or more sealing layer(s), wherein forming the one or more sealing layer(s) comprises
(i) mixing a polymerisable compound or a cross-linkable compound with a plurality of nanoparticles, the nanoparticles being reactive in that they are capable of interacting with moisture and/or oxygen by way of chemical reaction or through physical or physico-chemical interaction, thereby forming a sealing mixture,
(ii) applying the sealing mixture onto the barrier layer and polymerising the polymerisable compound or to cross-link the cross-linkable compound to form a polymer or oligomer under conditions allowing the nanoparticles to be encapsulated by the formed polymer or oligomer,
wherein the nanoparticles are encapsulated by encapsulation shells comprising a polymeric or oligomeric encapsulation material, and wherein the encapsulation shells partially or entirely cover the surface of the nanoparticles.

11. The method of claim 10,
(a) further comprising adding a surfactant to the sealing mixture, or
(b) further comprising adding a surface modifying compound to the sealing mixture, or
(c) wherein providing the one or more barrier layer(s) comprises forming the one or more barrier layer(s).

12. The method of claim 10 or 11, wherein the sealing mixture is applied onto the barrier layer via conformal deposition.

13. The method of any one of claims 10 to 12, wherein after being deposited onto the barrier layer the sealing mixture is exposed to conditions that initiate polymerization of the polymerisable compound or cross-linking the cross-linkable compound.

14. The method of any one of claims 10 to 13, wherein mixing of the polymerisable or cross-linkable compound with the plurality of nanoparticles in step (i) comprises mixing about 20 wt.-% dry form or less of the monomer to 80 wt.-% dry form or more of the nanoparticles (weight ratio 1:4 or less).

15. Use of an encapsulation barrier stack according to any of claims 1 to 9
(a) in preparing food packaging or pharmaceutical packaging or medical packaging; or
(b) for encapsulating a moisture and/or oxygen sensitive device.
